# EUROPEAN PATENT APPLICATION

(11) **EP 4 761 548 A1**
(43) Date of publication of application: **17.06.2026**
(21) Application number: 25211905.2
(22) Date of filing: 29.10.2025
(51) Int. Cl.: H10K 59/80

(54) **DISPLAY DEVICE**

(30) Priority: 10.12.2024 KR 20240182786
(71) Applicant: LG Display Co., Ltd., Seoul, 07336 (KR)
(72) Inventor: KIM, MyeongJun, 10845 Paju-si (KR); JANG, Wooyeong, 10845 Paju-si (KR)
(74) Representative: Ter Meer Steinmeister & Partner

(57) **Abstract**

Provided is a display device. The display device includes a display panel. The display panel includes a non-bending area including a display area and a non-display area configured to surround the display area, the display area is an area in which a plurality of light-emitting elements is disposed. The display panel further includes a bending area extending from one side of the non-display area. The display device further includes a polarizing plate disposed on the display panel in the non-bending area. The display device further includes a bonding layer disposed between the display panel and the polarizing plate in the non-bending area. The display device further includes at least one non-bonding pattern configured to overlap at least a part of an outermost peripheral portion of the polarizing plate and provided on one surface of the bonding layer.

## Description

This application claims priority of Korean Patent Application No. 10-2024-0182786 filed on December 10, 2024, in the Korean Intellectual Property Office.

### BACKGROUND

### Field

The specification relates to a display device, and more particularly, to a display device capable of suppressing a panel crack.

### Description of the Related Art

Image display devices, which visually implement various electrical information signals on screens, are key technologies in the information and communication era. The range of applications of image display devices expands beyond computer monitors and TVs to include personal mobile devices.

Various display devices, which are thin in thickness and light in weight and have excellent performance and low power consumption, have been developed. Examples of the display devices may include a liquid crystal display device (LCD), a field emission display device (FED), an organic light-emitting display device (OLED), and the like.

Recently, display devices have been made by forming display parts, lines, and the like on substrates made of flexible plastic materials and having flexibility. The display devices are manufactured to be stretchable in particular directions and variously changeable in shapes, and thus attract attention.

### SUMMARY

An object is to provide a display device capable of suppressing damage to a display panel caused by thermal deformation.

Objects of the present disclosure are not limited to the above-mentioned objects, and other objects, which are not mentioned above, can be clearly understood by those skilled in the art from the following descriptions.

The object is solved by the features of the independent claims. Preferred embodiments are given in the dependent claims.

According to an aspect of the disclosure, there is provided a display device. The display device includes a display panel. The display panel includes a non-bending area including a display area and a non-display area configured to surround the display area, the display area is an area in which a plurality of light-emitting elements is disposed. The display panel further includes a bending area extending from one side of the non-display area. The display device further includes a polarizing plate disposed on the display panel in the non-bending area. The display device further includes a bonding layer disposed between the display panel and the polarizing plate in the non-bending area. The display device further includes at least one non-bonding pattern configured to overlap at least a part of an outermost peripheral portion of the polarizing plate and provided on one surface of the bonding layer.

According to another aspect of the disclosure, there is provided a display device. The display device includes a display panel including a display area and a non-display area disposed outside the display area, the non-display area including a first non-display area configured to surround the display area, a bending area extending from one side of the first non-display area, and a second non-display area extending from the bending area. The display device further includes a polarizing plate disposed on the display panel in the entire display area and at least a part of the first non-display area. The display device further includes a bonding layer disposed between the display panel and the polarizing plate. The bonding layer includes at least one non-bonding pattern area provided on a top or bottom surface of an outer peripheral portion thereof, and a bonding area excluding the non-bonding pattern area.

Other detailed matters of the embodiments are included in the detailed description and the drawings.

In the following optional features will be provided which might be combined with the above mentioned aspects of the disclosure alone, in combination or in sub combination.

In one or more embodiments, the at least one non-bonding pattern may be provided in the non-display area between the display area and the bending area.

In one or more embodiments, the at least one non-bonding pattern may include a first non-bonding pattern extending along a boundary with the bending area. Preferably, the first non-bonding pattern integrally extends along the boundary with the bending area.

In one or more embodiments, the at least one non-bonding pattern may include a second non-bonding pattern disposed along the boundary with the bending area. Preferably, the second non-bonding pattern integrally extends along the boundary with the bending area.

In one or more embodiments, the at least one non-bonding pattern may be disposed to be closer to the display area than the first non-bonding pattern to the display area.

In one or more embodiments, the at least one non-bonding pattern may include a plurality of first non-bonding patterns spaced apart from one another along a boundary with the bending area.

In one or more embodiments, the display device may comprise an encapsulation part configured to cover the plurality of light-emitting elements in the display area; a touch buffer layer disposed on the encapsulation part; a plurality of touch electrodes disposed on the touch buffer layer; and a plurality of touch connection lines disposed in the non-display area between the display area and the bending area, extending to the display area, and electrically connected to the plurality of touch electrodes.

In one or more embodiments, the plurality of first non-bonding patterns may each overlap the touch connection line.

In one or more embodiments, the at least one non-bonding pattern may include a first non-bonding pattern disposed in the non-display area and configured to surround the display area.

In one or more embodiments, the at least one non-bonding pattern may include a second non-bonding pattern disposed in the non-display area.

In one or more embodiments, the at least one non-bonding pattern may be configured to surround the display area.

In one or more embodiments, the at least one non-bonding pattern may be disposed to be closer to the display area than the first non-bonding pattern to the display area.

In one or more embodiments, the display device may comprise a protective member disposed on the display panel in the bending area.

In one or more embodiments, a lateral portion of the polarizing plate and a lateral portion of the bonding layer may be each in contact with a lateral portion of the protective member in a first state.

In one or more embodiments, the lateral portion of the polarizing plate may be not in contact with the lateral portion of the protective member in a second state.

In one or more embodiments, a distance between the lateral portion of the bonding layer and the lateral portion of the protective member may be shorter than a distance between the lateral portion of the polarizing plate and the lateral portion of the protective member when the state of the display panel switches from the first state to the second state.

In one or more embodiments, one surface of the at least one non-bonding pattern may adjoin the bonding layer and may have a bonding force.

In one or more embodiments, the other surface of the at least one non-bonding pattern may adjoin the polarizing plate or the display panel and has no bonding force.

In one or more embodiments, the non-display area may include a first non-display area configured to surround the display area.

In one or more embodiments, the non-display area may include a bending area extending from one side of the first non-display area.

In one or more embodiments, the non-display area may include a second non-display area extending from the bending area.

In one or more embodiments, a polarizing plate may be disposed on the display panel in the entire display area and at least a part of the first non-display area.

In one or more embodiments, a bonding layer may be disposed between the display panel and the polarizing plate.

In one or more embodiments, the bonding layer may include at least one non-bonding pattern area provided on a top or bottom surface of an outer peripheral portion thereof.

In one or more embodiments, a bonding area may exclude the non-bonding pattern area.

In one or more embodiments, the at least one non-bonding pattern area may include a first non-bonding pattern area configured to overlap an outermost peripheral portion of the polarizing plate and integrally extending along the outermost peripheral portion of the polarizing plate.

In one or more embodiments, the first non-bonding pattern area may be provided in a first non-display area between the display area and the bending area.

In one or more embodiments, the first non-bonding pattern area may surround the display area in the first non-display area.

In one or more embodiments, the at least one non-bonding pattern area may include a second non-bonding pattern area spaced apart from the first non-bonding pattern area, disposed inward of the first non-bonding pattern area, and integrally extending along the outermost peripheral portion of the polarizing plate.

In one or more embodiments, the first non-bonding pattern area and the second non-bonding pattern area may be provided in a first non-display area between the display area and the bending area.

In one or more embodiments, the first non-bonding pattern area and the second non-bonding pattern area may surround the display area in the first non-display area.

In one or more embodiments, the at least one non-bonding pattern area may include a plurality of first non-bonding pattern areas provided in a first non-display area between the display area and the bending area and spaced apart from one another along a boundary with the bending area.

In one or more embodiments, the plurality of first non-bonding pattern areas may each overlap the outermost peripheral portion of the polarizing plate.

In one or more embodiments, a bottom surface of the bonding layer having a bonding force may be bonded to the display panel and a top surface of the bonding layer, from which the bonding force is removed, may be not bonded to the polarizing plate in the at least one non-bonding pattern area.

In one or more embodiments, a top surface of the bonding layer having a bonding force may be bonded to the polarizing plate and a bottom surface of the bonding layer, from which the bonding force is removed, may be not bonded to the display panel in the at least one non-bonding pattern area.

In one or more embodiments, the display device may comprise a non-bonding pattern member having a bonding force only on one of two opposite surfaces thereof.

In one or more embodiments, one surface of the non-bonding pattern member and the top or bottom surface of the bonding layer may be bonded in the non-bonding pattern area.

In the specification, the bonding layer having a non-bonding pattern is disposed between the polarizing plate and the display panel of the display device, such that the bonding layer may move independently of the polarizing plate.

According to the specification, even though the polarizing plate is thermally expanded and contracted repeatedly because of exposure to a periodical, repetitive temperature change between high and low temperatures, the separation between the polarizing plate and the display panel may be suppressed, thereby mitigating stress to be applied to the display panel and suppressing the occurrence of a crack defect.

According to the specification, the reliability of the display device may be ensured, such that the lifespan may be extended, and the display device may operate with low power consumption.

The effects according to the disclosure are not limited to the contents exemplified above, and more various effects are included in the present specification.

### BRIEF DESCRIPTION OF DRAWINGS

The above and other aspects, features and other advantages of the disclosure will be more clearly understood from the following detailed description taken in conjunction with the accompanying drawings, which illustrate in:
FIG. 1 a block diagram of a display device of an embodiment of the specification;
FIG. 2 a top plan view of the display device of the embodiment of the present specification;
FIG.3 perspective view for a bent state of the display device of the embodiment of the specification;
FIG. 4 a drive circuit diagram of a subpixel of the display device of the embodiment;
FIG. 5 a cross-sectional view taken along line I-I' in FIG. 2;
FIG. 6 a cross-sectional view taken along line II-II' in FIG. 2;
FIG. 7 a view illustrating one example of a cross-section of the display device of the embodiment;
FIG. 8 a view of another example of the cross-section of the display device of the embodiment;
FIG. 9 a top plan view of a display device of another embodiment of the specification;
FIG. 10 a cross-section of the display device of another embodiment of the specification;
FIG. 11 a top plan view of a display device of still another embodiment of the specification;
FIG. 12 a top plan view of the display device of yet another embodiment of the specification;
FIG. 13 a cross-sectional view taken along line III-III' in FIG. 12;
FIG. 14 a top plan view of a display device of still yet another embodiment of the specification; and
FIG. 15 is a cross-sectional view taken along line IV-IV' in FIG. 14.

### DETAILED DESCRIPTION OF THE EMBODIMENT

Advantages and characteristics of the disclosure and a method of achieving the advantages and characteristics will be clear by referring to embodiments described below in detail together with the accompanying drawings. However, the disclosure is not limited to the embodiments disclosed herein but will be implemented in various forms. The embodiments are provided by way of example only so that those skilled in the art can fully understand the disclosures of the present disclosure and the scope of the disclosure.

The shapes, sizes, ratios, angles, numbers, and the like illustrated in the accompanying drawings for describing the embodiments of the disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "comprising" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, other layer or other element may be interposed therebetween, or, it may be directly on the another element or layer.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Same reference numerals generally denote same elements throughout the specification.

A size and a thickness of each component illustrated in the drawing are illustrated for convenience of description, and the disclosure is not limited to the size and the thickness of the component illustrated.

In the specification, a "display device" may include a display device which includes a display panel and a driver for driving the display panel, in a narrow sense, such as a liquid crystal module (LCM), an organic light emitting module (OLED module), and a quantum dot module. Further, the "display device" may further include a set electronic apparatus or a set apparatus (or a set device) which is a complete product or a final product including an LCM, an OLED module, a QD module, etc., such as a notebook computer, a television, or a computer monitor, an automotive display device or equipment display device including another type of vehicle and a mobile electronic apparatus including a smart phone or an electronic pad.

Accordingly, the display device of the disclosure may include not only a display device itself in a narrow sense such as an LCM, an OLED module, a QD module, etc., but also an applied product or a set apparatus which is a final consumer device including the LCD, the OLED module, the QD module, etc.

Further, in some cases, the LCM, the OLED module, or the QD module which is configured by a display panel and a driver may be represented as "a display device" in a narrow sense and an electronic device as a complete product including the LCM, the OLED module, and the QD module may be represented as a "set apparatus". For example, the display device in the narrow sense includes an LCD display panel, an OLED display panel, a quantum dot display panel and a source PCB which is a controller for driving the display panel. In contrast, the set apparatus may be a concept further including a set PCB which is a set controller which is electrically connected to the source PCB to control the entire set apparatus.

As a display panel used in the embodiment of the disclosure, any type of display panel such as a liquid crystal display panel, an OLED display panel, a quantum dot (QD) display panel, and an electroluminescent display panel may be used. The display panel of the present embodiment is not limited to a specific display panel in which a bezel is bent with a flexible substrate for the OLED display panel and a back plate support structure therebelow. Further, a display panel used for the display device according to the embodiment of the disclosure is not limited to a shape or a size of the display panel.

For example, when the display panel is an OLED display panel, the display panel may include a plurality of gate lines, data lines, and pixels formed at intersecting areas of the gate lines and/or data lines. Further, the display panel may be configured to include an array including a thin film transistor which is an element to selectively apply a voltage to each pixel, a light emitting diode layer on the array, an encapsulation substrate or an encapsulation layer, and the like disposed on the array so as to cover the light emitting diode layer. The encapsulation layer may protect the thin film transistor the light emitting diode layer, and the like from external impacts and may suppress the permeation of moisture or oxygen into the light emitting diode layer. Further, a layer formed on the array may include an inorganic light emitting layer, for example, a nano-sized material layer, quantum dots, or the like.

The features of various embodiments of the disclosure can be partially or entirely adhered to or combined with each other and can be interlocked and operated in technically various ways, and the embodiments can be carried out independently of or in association with each other.

Hereinafter, a display device according to embodiments of the disclosure will be described in detail with reference to accompanying drawings.

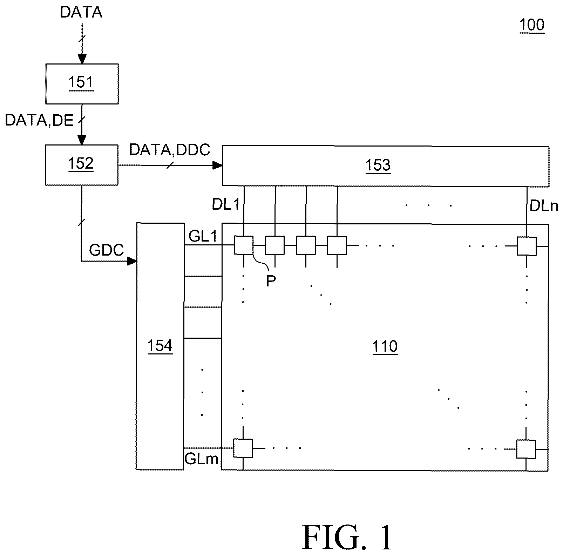

FIG. 1 is a block diagram of a display device of an embodiment of the specification.

With reference to FIG. 1, a display device 100 of an embodiment of the specification may include an image processor 151, a timing controller 152, a data driver 153, a gate driver 154. and a display panel 110.

The image processor 151 may output a data signal DATA, a data enable signal DE, and the like supplied from the outside. The image processor 151 may output one or more of a vertical synchronizing signal, a horizontal synchronizing signal, and a clock signal in addition to the data enable signal DE.

The timing controller 152 receives the data signal DATA in addition to the data enable signal DE or the driving signals including the vertical synchronizing signal, the horizontal synchronizing signal, and the clock signal from the image processor 151. On the basis of the driving signal, the timing controller 152 may output a gate timing control signal GDC for controlling an operation timing of the gate driver 154 and output a data timing control signal DDC for controlling an operation timing of the data driver 153.

In response to the data timing control signal DDC supplied from the timing controller 152, the data driver 153 may sample and latch the data signal DATA supplied from the timing controller 152, convert the data signal DATA into a gamma reference voltage, and output the gamma reference voltage. The data driver 153 may output the data signal DATA through data lines DL1 to DLn. The data driver 153 may be provided in the form of an integrated circuit (IC).

The gate driver 154 may output the gate signal while shifting a level of the gate voltage in response to the gate timing control signal GDC supplied from the timing controller 152. The gate driver 154 may output the gate signal through gate lines GL1 to GLm. The gate driver 154 may be provided in the form of an integrated circuit (IC) or formed on the display panel 110 in a gate-in-panel (GIP) manner.

In addition, in order to provide a touch sensing function, the display device 100 of the embodiment of the specification may further include a touch detection part including a plurality of touch electrodes, and a touch sensing circuit configured to supply a touch driving signal to the touch detection part, detect a touch sensing signal from the touch detection part, and sense a touch position (or coordinate) and whether a user's touch is made.

For example, the touch sensing circuit may include a touch drive circuit configured to supply the touch driving signal to the touch detection part and detect the touch sensing signal from the touch detection part, and a touch controller configured to sense a touch position and/or whether the user's touch is made on the basis of the touch sensing signal detected by the touch drive circuit. The touch drive circuit and the touch controller may be implemented as separate components or integrated into a single component in some instances.

Meanwhile, the data driver 153, the gate driver 154, and the touch drive circuit may each be implemented as one or more integrated circuits. The data driver 153, the gate driver 154, and the touch drive circuit may each be implemented as a chip-on-glass (COG) type, a chip-on-film (COF) type, or a tape carrier package (TCP) type in a standpoint related to the electrical connection with the display panel 110.

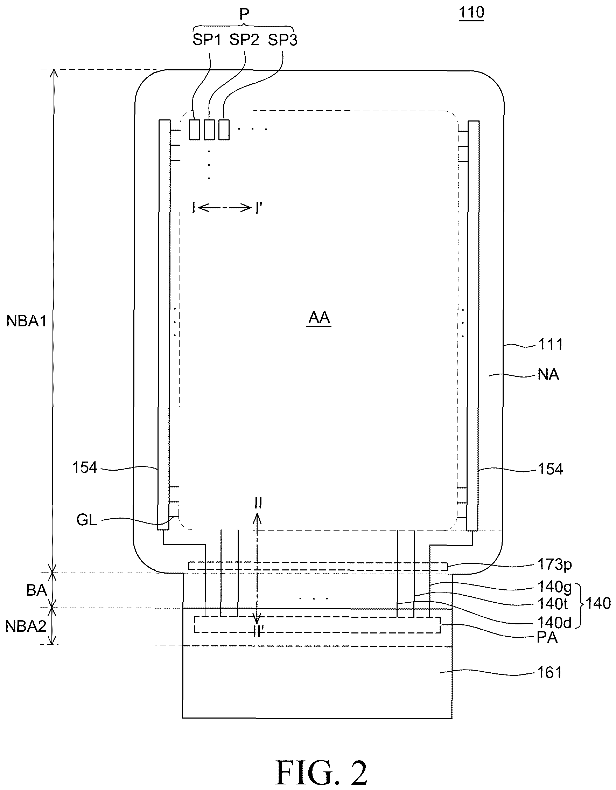

FIG. 2 is a top plan view of the display device of the embodiment of the specification.

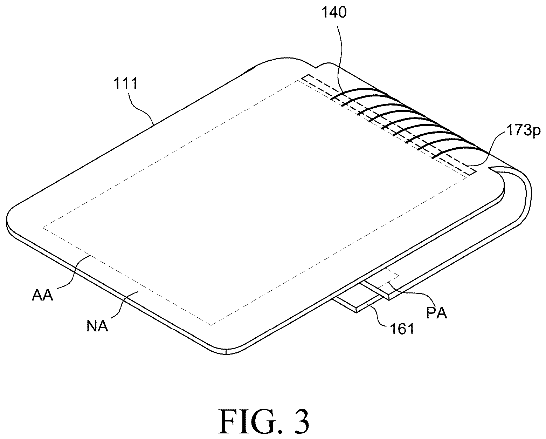

Further, FIG. 3 is a perspective view illustrating a bent state of the display device of the embodiment of the specification.

The display panel 110 of the display device 100 of the embodiment of the specification is a panel for implementing images. The display panel 110 may include a substrate 111 on which light-emitting elements for implementing images, circuits for operating the light-emitting elements, lines, components, and the like are disposed, and a circuit element 161 configured to supply a driving signal to a display area AA.

The display panel 110 includes a plurality of pixels P, and the plurality of pixels P may each display images while emitting light in response to the data signal DATA and the gate signal supplied from the data driver 153 and the gate driver 154.

One pixel P is configured by a plurality of subpixels. One pixel P may include three or more subpixels that emit light beams with wavelengths for implementing different colors. For example, in the display device 100 according to the embodiment of the present specification, one pixel P may include three subpixels SP1, SP2, and SP3 configured to emit light beams with red, green, and blue colors. However, the number of subpixels included in one pixel P is not limited thereto. For example, one pixel P may further include a subpixel configured to emit a light beam with a white color in addition to the subpixels configured to emit light beams with red, green, and blue colors. The subpixel may have one or more different light-emitting areas depending on luminous properties.

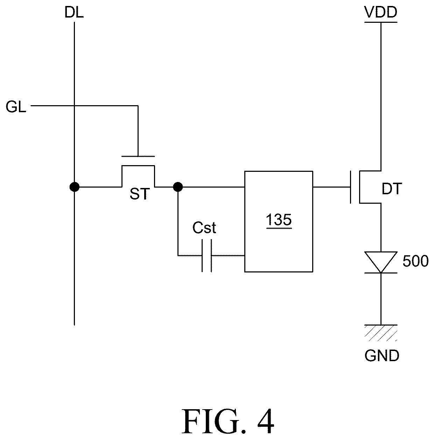

The plurality of subpixels SP may each include a light-emitting element, and a pixel drive circuit configured to control the amount of current flowing to the light-emitting element. The pixel drive circuit may include a plurality of driving thin-film transistors (thin film transistor (TFT)). The pixel drive circuit will be described in detail with reference to FIG. 4.

FIG. 4 is a drive circuit diagram of the subpixel of the display device of the embodiment of the specification.

With reference to FIG. 4, the subpixel of the display panel 110 according to the embodiment of the present specification may include a switching transistor ST, a driving transistor DT, a compensating circuit 135, and a light-emitting element 500.

The light-emitting element 500 may operate to emit light in accordance with a drive current produced by the driving transistor DT.

The switching transistor ST may perform a switching operation so that the data signal supplied through the data line DL is stored, as a data voltage, in a capacitor Cst in response to the gate signal supplied through the gate line GL.

The driving transistor DT may operate such that a predetermined drive current flows between a high-potential power line VDD and a low-potential power line GND while corresponding to the data voltage stored in the capacitor Cst.

In the embodiment of the specification, it is assumed that the display device 100 is an organic light-emitting display device. However, the specification is not limited thereto. For example, in case that the display device 100 is an organic light-emitting display device, the subpixel may include a light-emitting element including an anode electrode, a light-emitting layer on the anode electrode, and a cathode electrode on the light-emitting layer. In this case, the light-emitting element may include an organic light-emitting layer as the light-emitting layer and further include a hole transport layer, a hole injection layer, an electron injection layer, and an electron transport layer in addition to the organic light-emitting layer. Meanwhile, in another example, in case that the display device 100 is a liquid crystal display device, the display device 100 is configured to include a liquid crystal layer that is a display part.

In addition, the pixel drive circuit of the subpixel SP of the embodiment of the specification may include a driving transistor, a switching transistor, a capacitor, the gate line GL, the data line DL, and lines connected to a power source for operating the pixel. In this case, the light-emitting element may operate to emit light in accordance with the drive current produced by the driving transistor. The switching transistor may perform a switching operation so that the data signal supplied through the data line DL is stored, as a data voltage, in the capacitor in response to the gate signal supplied through the gate line GL. The driving transistor may operate such that a predetermined drive current flows between the high-potential power line and the low-potential power line while corresponding to the data voltage stored in the capacitor.

The example has been described above in which the subpixel SP has a 2T (Transistor) 1C (Capacitor) structure including one switching transistor, one driving transistor, and one capacitor in the display device 100 of the embodiment of the specification.

In another example, the subpixel SP of the display device 100 of the embodiment of the specification may further include the compensating circuit 135. The compensating circuit 135 is a circuit for compensating for a threshold voltage or the like of the driving transistor. The compensating circuit 135 may include one or more compensating thin-film transistors and one or more compensating capacitors. In this case, the configurations and structures of the compensating thin-film transistor and the compensating capacitor are not limited thereto, but may be variously implemented in accordance with compensation methods. For example, in case that the compensating circuit is added to the subpixel, the pixel may have various structures such as 3T1C, 4T2C, 5T2C, 6T1C, 6T2C, 7T1C, or 7T2C.

With reference back to FIG. 2, the substrate 111 of the display panel 110 may include the display area AA, and a non-display area NA disposed outside the display area AA. The non-display area NA may include a first non-display area configured to surround a periphery of the display area AA, a bending area BA extending from one side of the first non-display area, and a second non-display area extending from the bending area BA.

In the embodiment of the specification, for example, a structure is described in which the first non-display area surrounds a front surface of the display area AA. However, the specification is not limited thereto. The first non-display area may be present only in an outer partial area of the display area AA.

The substrate 111 of the display panel 110 may be defined by a first non-bending area NBA1 including the display area AA and the first non-display area, the bending area BA extending from the first non-bending area NBA1, and a second non-bending area NBA2 extending from the bending area BA. As shown in FIG. 2, the display panel 110 may include a non-bending area NBA1 and a bending area BA extending from one side of the non-bending area NBA1, and the non-bending area NBA1 may include a display area AA in which a plurality of light-emitting elements is disposed, and a non-display area NA configured to surround the display area AA.

FIG. 2 illustrates a state made before the substrate 111 is bent.

The non-display area NA of the substrate 111 is an area in which various lines, circuits, and the like are disposed to operate the subpixels SP1, SP2, and SP3 disposed in the display area AA. Because the non-display area NA is not an area in which images are displayed, the non-display area NA does not need to be visually recognized from a front surface of the display panel 110. Therefore, a partial area of the non-display area NA of the substrate 111 may be bent toward a rear surface of the display panel 110. For example, as illustrated in FIG. 3, a partial area of the non-display area NA of the substrate 111 may be bent toward the rear surface of the display panel 110 so that the bending area BA provided at one side edge of the substrate 111 has a predetermined curvature. In this case, a pad area PA may be positioned on the rear surface of the display panel 110 and overlap the display area AA. Therefore, it is possible to reduce the non-display area NA while ensuring an area for the line and the drive circuit.

The second non-bending area NBA2 of the substrate 111 may include the pad area PA in which a plurality of pad parts are disposed. The plurality of pad parts may include pads (e.g., metal patterns) connected to an external module, e.g., a flexible printed circuit board (FPCB), a chip-on-film (COF), and the like. For example, the plurality of pad parts may include a display pad part electrically connected to the subpixels and including a plurality of signal pads configured to transmit various types of signals, power, and the like for operating the subpixels.

A plurality of connection lines 140 may be disposed between the display area AA and the second non-display area of the substrate 111, i.e., disposed in the first non-display area and the bending area BA.

The connection lines 140 include a plurality of gate connection lines 140g configured to transmit signals (e.g., voltages) from the external module to a gate driving part included in the gate driver 154 or the display area AA. The gate driving part may provide a gate signal to the thin-film transistor of the pixel drive circuit and include various gate drive circuits. In the display device 100 of the embodiment of the specification, the gate driving part may be a gate-in-panel (GIP) on which the gate drive circuits are formed directly on the substrate 111.

The connection lines 140 include a plurality of data connection lines 140d configured to transmit data signals, which are supplied from the external module and used to display images, to the display area AA.

The connection lines 140 may further include power connection lines configured to transmit various voltages, such as the high-potential voltage and the low-potential voltage, in addition to the gate signal and the data signal. The power connection lines may transmit voltages, which are supplied from the external module, to the display area AA. The power connection lines may be connected to the low-potential voltage line, the high-potential voltage line, and a gate low-voltage line and/or a gate high-voltage line included in the gate driving part. However, the specification is not limited thereto.

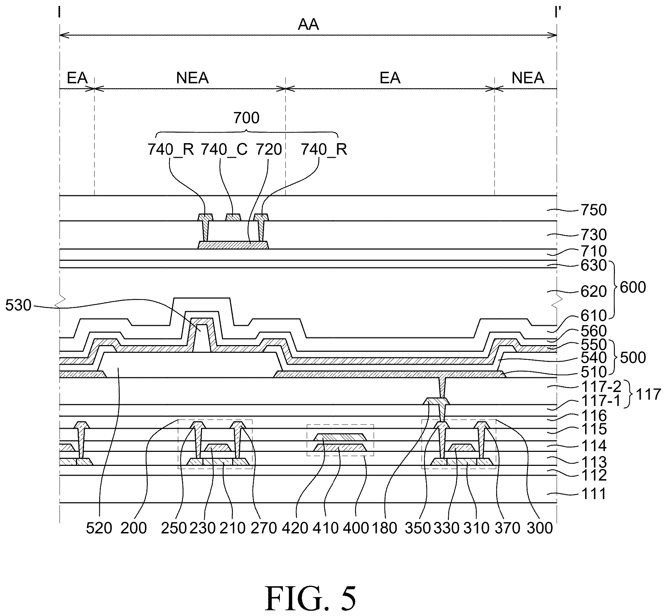

A touch detection layer may be disposed on the display area AA of the substrate 111 and disposed above an encapsulation layer configured to cover the light-emitting element of the subpixel. The touch detection part including the plurality of touch electrodes is disposed on the touch detection layer. The touch detection layer will be described more specifically with reference to FIG. 5.

The plurality of pad parts disposed in the pad area PA of the substrate 111 may include a touch pad part including a plurality of touch pads electrically connected to the plurality of touch electrodes of the touch detection layer.

The connection lines 140 further include a plurality of touch connection lines 140t configured to electrically connect the plurality of touch electrodes and the plurality of touch pads.

For example, the connection line 140 may be made of an electrically conductive material. The connection line 140 may be made of an electrically conductive material with excellent flexibility to reduce the occurrence of a crack when the substrate 111 is bent. For example, the connection line 140 may be made of an electrically conductive material, such as gold (Au), silver (Ag), or aluminum (Al), with excellent flexibility. The connection line 140 may be made of one of various electrically conductive materials used for the display area AA. The connection line 140 may be made of an alloy of molybdenum (Mo), chromium (Cr), titanium (Ti), nickel (Ni), neodymium (Nd), copper (Cu), silver (Ag), and/or magnesium (Mg).

The connection line 140 may be configured as a multilayer structure including various electrically conductive materials. For example, the connection line 140 may be configured as a three-layer structure of titanium (Ti)/aluminum (Al)/titanium (Ti). However, the present specification is not limited thereto.

The connection lines 140 formed in the bending area BA receive a tensile force in case that the connection lines 140 are bent. For example, the highest tensile force is applied to the line 140 extending in a direction identical to a bending direction, which may cause cracks or disconnection. Therefore, the line 140 is not disposed to extend in the bending direction. At least some of the lines 140 included and disposed in the bending area BA may be disposed to extend in a direction different from the bending direction, e.g., in an oblique direction, which may minimize a tensile force.

The connection lines 140 according to the embodiment of the present specification may be disposed as a multilayer structure (or dual wiring structure) in the non-display area NA including the bending area BA. Therefore, a margin for disposing the lines may be provided, which may facilitate the line/electrode arrangement design.

The circuit element 161 may be attached to the second non-bending area NBA2 of the substrate 111. The circuit element 161 may be bonded to the second non-bending area NBA2 of the substrate 111 and overlap the pad area PA of the substrate 111. The circuit element 161 may include bumps (or terminals). The bump of the circuit element 161 may adjoin the pads in the pad area PA through an anisotropic conductive film (ACF).

The circuit element 161 may be a chip-on film (COF) made by mounting a drive integrated circuit (IC) on a flexible film. The circuit element 161 may be implemented as a COG type joined directly to the pads on the substrate 111 by a chip-on glass (COG) process. In addition, the circuit element 161 may be a flexible circuit such as a flexible flat cable (FFC) or a flexible printed circuit (FPC).

The driving signals, e.g., the gate signal, the data signal, the touch driving signal, and the like, which are received through the circuit element 161, may be supplied to the gate lines, the data lines, and the touch electrodes in the display area AA through the connection lines 140.

A structure of the subpixel disposed in the display area AA of the substrate 111 described with reference to FIG. 2 will be described with reference to FIG. 5.

FIG. 5 is a cross-sectional view taken along line I-I' in FIG. 2.

With reference to FIG. 5, a light-emitting element layer 500 for displaying images may be disposed on the substrate 111, and a plurality of first thin-film transistors 200 and a plurality of second thin-film transistors 300 for operating the light-emitting element layer 500 may be disposed on the substrate 111.

The substrate 111 may support various constituent elements of the display device.

The substrate 111 may be made of glass or a plastic material having flexibility. For example, the substrate 111 may be made of at least one of polyimide (PI), polymethylmethacrylate (PMMA), polyethylene terephthalate (PET), polyether sulfone, and polycarbonate (PC). However, the present specification is not limited thereto. In case that the substrate 111 is made of polyimide, the substrate 111 may include two polyimide layers. An inorganic film may be further disposed between the two polyimide layers. However, the present specification is not limited thereto.

For example, elements and functional layers formed on the substrate 111 may conceptually refer to a switching thin-film transistor, a driving thin-film transistor connected to the switching thin-film transistor, an organic light-emitting element connected to the driving thin-film transistor, a protective layer, and the like. However, the present specification is not limited thereto.

A first insulation layer 112 may be disposed on the substrate 111. For example, the first insulation layer 112 may be disposed on an entire surface of the substrate 111.

The first insulation layer 112 may inhibit the material in the substrate 111 from moving to the thin-film transistor or the semiconductor layer during a deposition process.

The first insulation layer 112 may be made of an insulating inorganic material such as silicon nitride (SiNx) or silicon oxide (SiOx). However, the present specification is not limited thereto. In addition, the first insulation layer 112 may be made of an insulating organic material or the like. The first insulation layer 112 may be configured as a single layer or multilayer made of silicon nitride (SiNx) and/or silicon oxide (SiOx). However, the present specification is not limited thereto. In case that the first insulation layer 112 is configured as a multilayer, silicon oxide (SiOx) and silicon nitride (SiNx) may be formed alternately. However, the present specification is not limited thereto.

The first insulation layer 112 may be a buffer layer or a first buffer layer. The first insulation layer 112 may be excluded depending on the type and material of the substrate 111, the structure and type of the thin-film transistor, and the like.

A first thin-film transistor 200 and a second thin-film transistor 300 may be disposed on the first insulation layer 112.

The first thin-film transistor 200 may include a first semiconductor layer 210, a first gate electrode 230, a first source electrode 250, and a first drain electrode 270.

The second thin-film transistor 300 may include a second semiconductor layer 310, a second gate electrode 330, a second source electrode 350, and a second drain electrode 370.

In the display device 100 according to the embodiment of the present specification, the first thin-film transistor 200 may be a switching thin-film transistor, and the second thin-film transistor 300 may be a driving thin-film transistor. However, the present specification is not limited thereto. For convenience of description, FIG. 5 illustrates only the two thin-film transistors among various thin-film transistors. However, the display device 100 may also include other thin-film transistors. In addition, for convenience of description, FIG. 5 illustrates an upper gate (or top gate) structure in which the gate electrode, which constitutes the thin-film transistor, is positioned above a semiconductor layer. However, the present specification is not limited to this structure. Other structures, such as a lower gate (or bottom gate) structure in which the gate electrode is positioned below the semiconductor layer or a double gate structure in which the gate electrodes are positioned both above and below the semiconductor layer, may be implemented.

The first semiconductor layer 210 of the first thin-film transistor 200 and the second semiconductor layer 310 of the second thin-film transistor 300 may be disposed on the first insulation layer 112.

The first semiconductor layer 210 and the second semiconductor layer 310 may be made of polycrystalline semiconductor. However, the present specification is not limited thereto. For example, the polycrystalline semiconductor may be made of low-temperature polysilicon (LTPS) with high mobility. In case that the first semiconductor layer 210 and the second semiconductor layer 310 are made of polycrystalline semiconductor, energy power consumption is low, and reliability is excellent.

The first semiconductor layer 210 and the second semiconductor layer 310 may be made of oxide semiconductor. However, the present specification is not limited thereto. For example, the oxide semiconductor may be made of any one of indium-gallium-zinc-oxide (IGZO), indium-zinc-oxide (IZO), indium-gallium-tin-oxide (IGTO), and indium-gallium-oxide (IGO). In case that the first semiconductor layer 210 and the second semiconductor layer 310 are made of oxide semiconductor, the first semiconductor layer 210 and the second semiconductor layer 310 provide an excellent effect of blocking leakage current, thereby minimizing a change in luminance of the subpixel during a low-speed operation.

In case that the first semiconductor layer 210 and the second semiconductor layer 310 are made of polycrystalline semiconductor or oxide semiconductor, the first semiconductor layer 210 and the second semiconductor layer 310 may each have a conductive area in a partial area.

The first semiconductor layer 210 and the second semiconductor layer 310 may be made of amorphous silicon (a-Si), various organic semiconductor materials such as pentacene, or the like. However, the present specification is not limited thereto.

A second insulation layer 113 may be disposed in the entire area of the substrate 111 and disposed on the first semiconductor layer 210 and the second semiconductor layer 310.

The second insulation layer 113 may be disposed between the first semiconductor layer 210 and the first gate electrode 230 and insulate the first semiconductor layer 210 and the first gate electrode 230. The second insulation layer 113 may be made of an insulating inorganic material such as silicon nitride (SiNx) or silicon oxide (SiOx). However, the present specification is not limited thereto.

The second insulation layer 113 may have holes to electrically connect the first source electrode 250 and the first drain electrode 270 to the first semiconductor layer 210.

The first gate electrode 230 of the first thin-film transistor 200 and the second gate electrode 330 of the second thin-film transistor 300 may be disposed on the second insulation layer 113. The first gate electrode 230 may be disposed to overlap the first semiconductor layer 210, and the second gate electrode 330 may be disposed to overlap the second semiconductor layer 310.

In addition, a storage capacitor 400 may be disposed on the second insulation layer 113.

The storage capacitor 400 may include a first capacitor electrode 410 and a second capacitor electrode 420. The storage capacitor 400 may store the data voltage, which is applied through the data line, for a predetermined period of time and supply the data voltage to a first electrode 510.

The first capacitor electrode 410 of the storage capacitor 400 may be disposed on the second insulation layer 113.

For example, the first capacitor electrode 410 may be disposed on the same layer as the first gate electrode 230 and the second gate electrode 330 and formed by the same process as the first gate electrode 230 and the second gate electrode 330.

The first gate electrode 230, the second gate electrode 330, and the first capacitor electrode 410 may each be configured as a single layer or multilayer made of any one or more of molybdenum (Mo), copper (Cu), titanium (Ti), aluminum (Al), chromium (Cr), gold (Au), nickel (Ni), neodymium (Nd), tungsten (W), gold (Au), and transparent conductive oxide (TCO) and an alloy thereof. However, the present specification is not limited thereto.

A third insulation layer 114 may be disposed on the first gate electrode 230, the second gate electrode 330, and the first capacitor electrode 410, and the third insulation layer 114 may be disposed in the entire area of the substrate 111.

The third insulation layer 114 may be disposed between each of the first source electrode 250 and the first drain electrode 270 and the first gate electrode 230 and insulate each of the first source electrode 250 and the first drain electrode 270 and the first gate electrode 230. The third insulation layer 114 may have holes to electrically connect the first source electrode 250 and the first drain electrode 270 to the first semiconductor layer 210.

In addition, the third insulation layer 114 may be disposed between each of the second source electrode 350 and the second drain electrode 370 and the second gate electrode 330 and insulate each of the second source electrode 350 and the second drain electrode 370 and the second gate electrode 330. The third insulation layer 114 may have holes to electrically connect the second source electrode 350 and the second drain electrode 370 to the second semiconductor layer 310.

The third insulation layer 114 may be made of an insulating inorganic material such as silicon nitride (SiNx) or silicon oxide (SiOx). However, the present specification is not limited thereto. In addition, the third insulation layer 114 may be made of an insulating organic material or the like.

The second capacitor electrode 420 of the storage capacitor 400 may be disposed on the third insulation layer 114 and overlap the first capacitor electrode 410.

The second capacitor electrode 420 may be configured as a single layer or multilayer made of any one or more of molybdenum (Mo), copper (Cu), titanium (Ti), aluminum (Al), chromium (Cr), gold (Au), nickel (Ni), neodymium (Nd), tungsten (W), gold (Au), and transparent conductive oxide (TCO) and an alloy thereof. However, the present specification is not limited thereto.

A fourth insulation layer 115 may be disposed on the second capacitor electrode 420, and the fourth insulation layer 115 may be disposed in the entire area of the substrate 111.

The fourth insulation layer 115 may be disposed between each of the first source electrode 250 and the first drain electrode 270 and the first gate electrode 230 and insulate each of the first source electrode 250 and the first drain electrode 270 and the first gate electrode 230. The fourth insulation layer 115 may have holes to electrically connect the first source electrode 250 and the first drain electrode 270 to the first semiconductor layer 210.

In addition, the fourth insulation layer 115 may be disposed between each of the second source electrode 350 and the second drain electrode 370 and the second gate electrode 330 and insulate the second source electrode 350, the second drain electrode 370, and the second gate electrode 330. The fourth insulation layer 115 may have holes to electrically connect the second source electrode 350 and the second drain electrode 370 to the second semiconductor layer 310.

The fourth insulation layer 115 may be made of an insulating inorganic material such as silicon nitride (SiNx) or silicon oxide (SiOx). However, the present specification is not limited thereto. In addition, the fourth insulation layer 115 may be made of an insulating organic material or the like.

The first source electrode 250 and the first drain electrode 270 may be disposed on the fourth insulation layer 115, and the second source electrode 350 and the second drain electrode 370 may be disposed on the fourth insulation layer 115.

The first source electrode 250 and the first drain electrode 270 may each be electrically connected to the first semiconductor layer 210 through the holes of the second insulation layer 113, the third insulation layer 114, and the fourth insulation layer 115.

In addition, the second source electrode 350 and the second drain electrode 370 may each be electrically connected to the second semiconductor layer 310 through the holes of the second insulation layer 113, the third insulation layer 114, and the fourth insulation layer 115.

The first source electrode 250, the first drain electrode 270, the second source electrode 350, and the second drain electrode 370 may each be configured as a single layer or multilayer made of any one or more of molybdenum (Mo), copper (Cu), titanium (Ti), aluminum (Al), chromium (Cr), gold (Au), nickel (Ni), neodymium (Nd), tungsten (W), gold (Au), and transparent conductive oxide (TCO) and an alloy thereof. However, the present specification is not limited thereto. For example, the first source electrode 250, the first drain electrode 270, the second source electrode 350, and the second drain electrode 370 may each be configured as a three-layer structure of titanium (Ti)/aluminum (Al)/titanium (Ti) and made of conductive metallic materials. However, the present specification is not limited thereto.

A fifth insulation layer 116 may be disposed on the first source electrode 250, the first drain electrode 270, the second source electrode 350, and the second drain electrode 370, and the fifth insulation layer 116 may be disposed in the entire area of the substrate 111.

The fifth insulation layer 116 may protect the first thin-film transistor 200 and the second thin-film transistor 300. The fifth insulation layer 116 may be made of an insulating inorganic material such as silicon nitride (SiNx) or silicon oxide (SiOx). However, the present specification is not limited thereto. In addition, the fifth insulation layer 116 may be made of an insulating organic material or the like.

The fifth insulation layer 116 may have a hole to electrically connect the second thin-film transistor 300 to a connection electrode 180 or the first electrode 510. The fifth insulation layer 116 may be excluded depending on the structure and type and the like of the thin-film transistor.

A protective layer 117 may be disposed on the fifth insulation layer 116. For example, the protective layer 117 may be an insulation layer or a planarization layer. However, the present specification is not limited thereto.

The protective layer 117 may protect the thin-film transistor disposed below the protective layer 117 and mitigate or eliminate a level difference caused by various patterns. For example, the protective layer 117 may insulate the constituent elements disposed above and below the protective layer 117.

The protective layer 117 may be disposed as a single layer. However, the present specification is not limited thereto. The protective layer 117 may be disposed as a plurality of layers including two or more layers in consideration of the disposition of the electrodes.

In order for the display device to support high resolution, various types of signal lines increase in number, which makes it difficult to dispose all the lines on one layer while ensuring minimum intervals. Therefore, an additional layer needs to be configured on the protective layer 117 or the like. The additional layer may provide a margin for disposing the lines, thereby facilitating the design of the disposition of the electric wires and the electrodes. As described above, the protective layer 117 is configured as a multilayer. In case that a planarization layer is made of a dielectric material, the protective layer 117 may also be utilized to form capacitance between the metal layers.

In case that the protective layer 117 is disposed as two layers, the protective layer 117 may include a first protective layer 117-1 and a second protective layer 117-2. For example, the first protective layer 117-1 may be a sixth insulation layer, and the second protective layer 117-2 may be a seventh insulation layer. However, the present specification is not limited thereto.

A hole may be formed in the first protective layer 117-1, and a part of the connection electrode 180 may be disposed in the hole. In addition, the second protective layer 117-2 having a hole may be disposed on the first protective layer 117-1 and the connection electrode 180. A part of the first electrode 510 of the light-emitting element layer 500 may be disposed in the hole of the second protective layer 117-2. Therefore, the second thin-film transistor 300 and the first electrode 510 may be electrically connected through the connection electrode 180.

One end (or one part or one side) of the connection electrode 180 may be connected to the second thin-film transistor 300, and the other end (or the other part or the other side) of the connection electrode 180 may be connected to the first electrode 510 of the light-emitting element layer 500.

The connection electrode 180 may be further disposed on the first protective layer 117-1.

The connection electrode 180 may be configured as a single layer or multilayer made of any one or more of molybdenum (Mo), copper (Cu), titanium (Ti), aluminum (Al), chromium (Cr), gold (Au), nickel (Ni), neodymium (Nd), tungsten (W), gold (Au), and transparent conductive oxide (TCO) and an alloy thereof. However, the present specification is not limited thereto. For example, the connection electrode 180 may be configured as a three-layer structure of titanium (Ti)/aluminum (Al)/titanium (Ti) and made of conductive metallic materials.

The connection electrode 180 may be a first connection electrode. However, the present specification is not limited thereto. The connection electrode 180 may be excluded depending on the structure and type and the like of the display device 100.

The second protective layer 117-2 may be disposed on the first protective layer 117-1 and the connection electrode 180.

The first protective layer 117-1 and the second protective layer 117-2 may each be made of at least one of organic insulating materials such as benzocyclobutene (BCB), acrylic resin, epoxy resin, phenolic resin, polyamide resin, and polyimide resin. However, the present specification is not limited thereto.

The protective layer 117 may be disposed as three or more layers in consideration of the disposition of the electrodes.

The light-emitting element layer 500 may be disposed on the protective layer 117. The light-emitting element layer 500 may include the first electrode 510, an organic layer 540, and a second electrode 550.

For example, the first electrode 510 of the light-emitting element layer 500 may be disposed on the second protective layer 117-2.

The first electrode 510 may be configured to supply positive holes to the organic layer 540 and made of an electrically conductive material having a high work function. The first electrode may be an anode electrode. However, the present specification is not limited thereto.

In case that the display device 100 according to the embodiment of the present specification is a top-emission type display device, the first electrode 510 may serve as a reflective electrode configured to reflect light and be disposed by using an opaque electrically conductive material. For example, the first electrode 510 may be made of at least one of silver (Ag), aluminum (Al), gold (Au), molybdenum (Mo), tungsten (W), chromium (Cr), and an alloy thereof. However, the present specification is not limited thereto. For example, the first electrode 510 may have a three-layer structure of silver (Ag)/lead (Pb)/copper (Cu). Alternatively, the first electrode 510 may further include a transparent electrically conductive material layer, such as indium-tin-oxide (ITO), with a high work function.

In addition, in case that the display device 100 according to the embodiment of the present specification is a bottom-emission type display device, the first electrode 510 may be disposed by using a transparent electrically conductive material that transmits light. For example, the first electrode 510 may be made of at least one of indium-tin oxide (ITO) and indium-zinc oxide (IZO). However, the present specification is not limited thereto.

A bank 520 may be disposed on the first electrode 510 and the protective layer 117.

The bank 520 may distinguish between the plurality of subpixels. The bank 520 may define (or distinguish between) a light-emitting part configured to emit light and a non-light-emitting part configured not to emit light. The bank 520 may be disposed in the non-light-emitting part and have a bank hole through which the light-emitting part and the first electrode 510 are exposed. The bank 520 may be disposed to shield or cover an end (or partial area) of the first electrode 510. The bank 520 may minimize light blurring and suppress a color mixture occurring at various viewing angles.

The bank 520 may be made of at least one of the materials including inorganic insulating materials, such as silicon nitride (SiNx) or silicon oxide (SiOx), organic insulating materials such as benzocyclobutene (BCB), acrylic resin, epoxy resin, phenolic resin, polyamide resin, or polyimide resin, and a photosensitive agent including black pigment. However, the present specification is not limited thereto. For example, in case that the bank 520 includes a black material, it is possible to inhibit external light, internal reflected light, and/or scattered light scattered by a side surface of the first electrode 510 from entering the thin-film transistor and solve a problem of a deterioration in luminance of the display device.

At least one spacer 530 may be disposed on the bank 520. The spacer 530 may suppress damage to the organic layer 540 during the process for the organic layer 540 and minimize damage to the display device 100 caused by external impact.

The spacer 530 may be made of the same material as the bank 520 and formed simultaneously with the bank 520, or the spacer 530 and the bank 520 may be formed by separate processes. For example, the spacer 530 may be formed to be transparent, black, or colored. In addition, the spacer 530 may include a transparent material, a black material, or a colored material. However, the present specification is not limited thereto.

A thickness of the spacer 530 may be equal to or larger than a thickness of the bank 520. For example, the thickness of the spacer 530 may be 1 µm to 2 µm. However, the present specification is not limited thereto.

The organic layer 540 may be disposed on the first electrode 510 and the bank 520.

The organic layer 540 may include a light-emitting layer (EML) configured to emit light so that the plurality of subpixels may emit light beams with particular colors.

For example, the light-emitting layer may include one of a red light-emitting layer configured to emit red light, a green light-emitting layer configured to emit green light, a blue light-emitting layer configured to emit blue light, and a white light-emitting layer. In this case, in case that the organic layer 540 includes the white light-emitting layer, a color filter may be disposed above the organic layer 540 to convert white light, which is emitted from the white light-emitting layer, into light with a different color.

In addition, in addition to the light-emitting layer, the organic layer 540 may further include a hole injection layer (HIL), a hole transport layer (HTL), an electron blocking layer (EBL), a hole blocking layer (HBL), an electron transport layer (ETL), an electron injection layer (EIL), and the like. However, the embodiments of the present specification are not limited thereto. The light-emitting layer of the organic layer 540 may be disposed in each of the plurality of subpixels. At least one of the hole injection layer (HIL), the hole transport layer (HTL), the electron blocking layer (EBL), the hole blocking layer (HBL), the electron transport layer (ETL), and the electron injection layer (EIL) of the organic layer 540 may be disposed in the entire display area.

For example, when the positive holes, which are produced from the first electrode 510, and the electrons, which are produced from the second electrode 550, are injected into the light-emitting layer, the injected positive holes and the injected electrons may be combined to produce excitons, and light may be emitted when the produced excitons transition from an excited state to a ground state.

The organic layer 540 of the display device 100 according to the embodiment of the present specification may have a shape in which at least one light-emitting unit is disposed. For example, a stack structure may be configured by stacking a plurality of light-emitting units between the first electrode 510 and the second electrode 550. In this case, a charge generating layer may be further disposed between the plurality of light-emitting units. The light-emitting units may be disposed as a plurality of light-emitting units for each of the subpixels.

The second electrode 550 may be disposed on the organic layer 540. The second electrode 550 may be configured to supply the electrons to the organic layer 540 and made of an electrically conductive material with a low work function. The second electrode may be a cathode electrode. However, the present specification is not limited thereto.

In case that the display device 100 according to the embodiment of the present specification is a top-emission type display device, the second electrode 550 may be disposed by using a transparent electrically conductive material that transmits light. For example, the second electrode may be made of at least one of indium-tin oxide (ITO) and indium-zinc oxide (IZO). However, the present specification is not limited thereto. The second electrode 550 may be disposed by using a semitransparent electrically conductive material that transmits light. For example, the second electrode may be made of at least one of the alloys such as LiF/Al, CsF/Al, Mg:Ag, Ca/Ag, Ca:Ag, LiF/Mg:Ag, LiF/Ca/Ag, and LiF/Ca:Ag. However, the present specification is not limited thereto.

In case that the display device 100 according to the embodiment of the present specification is a bottom-emission type display device, the second electrode 550 may serve as a reflective electrode configured to reflect light and be disposed by using an opaque electrically conductive material. For example, the second electrode 550 may be made of at least one of silver (Ag), aluminum (Al), gold (Au), molybdenum (Mo), tungsten (W), chromium (Cr), and an alloy thereof. However, the present specification is not limited thereto.

An encapsulation part 600 may be disposed on the second electrode 550.

The encapsulation part 600 may protect the organic layer 540 from external moisture, oxygen, or foreign substances. For example, the encapsulation part 600 may suppress oxidation of the light-emitting material and the electrode material of the light-emitting element layer 500 by suppressing the permeation of oxygen and moisture from the outside.

The encapsulation part 600 may include a first encapsulation layer 610, a second encapsulation layer 620, and a third encapsulation layer 630. The first encapsulation layer 610, the second encapsulation layer 620, and the third encapsulation layer 630 may be structured to be alternately stacked. However, the present specification is not limited thereto.

The encapsulation part 600 may be made of a transparent material that transmits light emitted from the light-emitting layer.

The first encapsulation layer 610 and the third encapsulation layer 630 may be made of an inorganic material including at least one of silicon nitride (SiNx), silicon oxide (SiOx), and aluminum oxide (AlyOz). However, the present specification is not limited thereto. The first encapsulation layer 610 and the third encapsulation layer 630 may be formed by using a vacuum film deposition method such as a chemical vapor deposition (CVD) or an atomic layer deposition (ALD). However, the present specification is not limited thereto.

The first encapsulation layer 610 and the third encapsulation layer 630 may each be formed as a plurality of layers. For example, the first encapsulation layer 610 may have a three-layer structure of silicon oxide (SiOx)/silicon nitride (SiNx)/silicon oxide (SiOx). However, the present specification is not limited thereto. The first encapsulation layer 610 may have a four-layer structure of silicon oxide (SiOx)/silicon nitride (SiNx)/silicon oxide (SiOx)/silicon oxide (SiOx).

The second encapsulation layer 620 may cover foreign substances or particles that may occur during the process of manufacturing the display panel 110. The second encapsulation layer 620 may planarize a surface of the first encapsulation layer 610. For example, the second encapsulation layer 620 may be a particle cover layer. However, the present specification is not limited by the term.

The second encapsulation layer 620 may be made of an organic material, for example, polymer such as silicon oxycarbon (SiOCz), epoxy, polyimide, polyethylene, or acrylate. However, the present specification is not limited thereto. In addition, the second encapsulation layer 620 may be made of a thermosetting material or a photocurable material that is cured by heat or light.

The second encapsulation layer 620 may be formed by a method such as inkjet coating or slit coating. However, the present specification is not limited thereto. The second encapsulation layer 620 may be formed in various ways. For example, the second encapsulation layer 620 may be formed on the first encapsulation layer 610 by spraying or dropping a liquid organic material onto the display area AA on the substrate 111 having the first encapsulation layer 610 by using an inkjet device or a nozzle coating device. The organic material in a flowing state may be formed on an application area while a spray nozzle moves over the application area (or a target object moves while the nozzle is fixed).

Because the material, which constitutes the second encapsulation layer 620, has a property of low viscosity, the material may be in a state similar to a high-density liquid before the material is cured. In order to solve a problem in which the second encapsulation layer 620 spreads (flows) to a non-display area, a dam may be further disposed in a non-display area of the substrate 111 in the display device 100 according to the embodiment of the present specification.

A touch detection part 700 may be disposed on the encapsulation part 600.

The touch detection part 700 may include first touch electrodes 740_R, a first touch connection electrode 720, second touch electrodes, and a second touch connection electrode 740_C. The first touch electrode 740_R, the first touch connection electrode 720, the second touch electrode, and the second touch connection electrode 740_C may be disposed to partially overlap the bank 520.

The first touch electrode 740_R, the second touch electrode, the first touch connection electrode 720, and the second touch connection electrode 740_C may be formed to have mesh patterns in which metal lines intersect one another. The mesh pattern may have a rhombic shape. In addition, the shape of the mesh pattern may be a quadrangular shape, a pentagonal shape, a hexagonal shape, a circular shape, or an elliptical shape. However, the present specification is not limited thereto.

The first touch electrode 740_R, the second touch electrode, the first touch connection electrode 720, and the second touch connection electrode 740_C may be disposed by using an opaque electrically conductive material with low material resistance. For example, the first touch electrode 740_R, the second touch electrode, the first touch connection electrode 720, and the second touch connection electrode 740_C may each be configured as a single layer or multilayer made of any one or more of molybdenum (Mo), copper (Cu), titanium (Ti), aluminum (Al), chromium (Cr), gold (Au), nickel (Ni), neodymium (Nd), tungsten (W), gold (Au), and transparent conductive oxide (TCO) and an alloy thereof. However, the present specification is not limited thereto. For example, the first touch electrode 740_R, the second touch electrode, the first touch connection electrode 720, and the second touch connection electrode 740_C may each be configured as a three-layer structure of titanium (Ti)/aluminum (Al)/titanium (Ti) and made of conductive metallic materials. However, the present specification is not limited thereto. For example, the first touch electrode 740_R, the second touch electrode, the first touch connection electrode 720, and the second touch connection electrode 740_C may be made of the same material as the first source electrode 250, the first drain electrode 270, the second source electrode 350, and the second drain electrode 370. However, the present specification is not limited thereto.

A touch buffer layer 710 may be disposed on the encapsulation part 600.

The touch buffer layer 710 may inhibit external moisture or a liquid chemical (a developer, an etching liquid, or the like), which is used for the process of manufacturing the touch detection part 700, from permeating into the light-emitting element layer 500 including an organic material. In addition, the touch buffer layer 710 may inhibit metals of the plurality of touch electrodes disposed above the touch buffer layer 710 from being disconnected by external impact. The touch buffer layer 710 may block an interference signal that may occur when the touch detection part 700 operates. For example, the touch buffer layer 710 may be a touch buffer layer, a second buffer layer, or an eighth insulation layer. However, the present specification is not limited thereto.

The touch buffer layer 710 may be made of at least one of the materials including inorganic insulating materials, such as silicon nitride (SiNx) or silicon oxide (SiOx), and organic insulating materials such as benzocyclobutene (BCB), acrylic resin, epoxy resin, phenolic resin, polyamide resin, or polyimide resin. However, the present specification is not limited thereto.

The first touch connection electrode 720 may be disposed on the touch buffer layer 710.

For example, the first touch connection electrode 720 may be disposed between the first touch electrodes 740_R adjacent to each other in a first direction (or X-axis direction) and electrically connect the first touch electrodes 740_R spaced apart from each other. The first touch connection electrode 720 may be disposed to overlap the second touch connection electrode 740_C configured to connect the second touch electrodes adjacent to each other in a second direction (or Y-axis direction). As described above, the first touch connection electrode 720 and the second touch connection electrode 740_C may be formed on different layers and thus electrically insulated. For example, the first touch connection electrode 720 may be a connection electrode or a second connection electrode, and the second touch connection electrode 740_C may be a third connection electrode. However, the present specification is not limited thereto.

A touch insulation layer 730 may be disposed on the touch buffer layer 710 and the first touch connection electrode 720. For example, the touch insulation layer 730 may be a ninth insulation layer. However, the present specification is not limited thereto.

The touch insulation layer 730 may include holes to electrically connect the first touch connection electrode 720 and the first touch electrodes 740_R adjacent to each other. The touch insulation layer 730 may electrically insulate the second touch electrode and the second touch connection electrode 740_C.

The touch insulation layer 730 may be made of an organic material, for example, polymer such as silicon oxycarbon (SiOCz), epoxy, polyimide, polyethylene, or acrylate. However, the present specification is not limited thereto. The touch insulation layer 730 may be made of a thermosetting material or a photocurable material that is cured by heat or light.

In case that the touch insulation layer 730 is made of an inorganic material, the touch insulation layer 730 is disposed along stepped portions and curved portions of various constituent elements disposed below the touch insulation layer 730. Therefore, in case that the steep stepped and curved portions provided below the touch insulation layer 730 are not covered, some of the constituent elements in the display device may be visually recognized from the outside. This may be perceived by the user as a defect such as smudge, which degrades an aesthetic appearance to be provided to the users. In addition, an insulation layer made of an inorganic material has lower effectiveness in blocking moisture and oxygen, which permeate from the outside of the display device, than an insulation layer made of an organic material and cannot cover foreign substances or particles that may occur during the manufacturing process. Therefore, in the display device 100 according to the embodiment of the present specification, the touch insulation layer 730 is made of an organic material, thereby inhibiting the lines from being cracked and disconnected by mechanical stress in the bending area BA during or after a process of bending a plate during the process of manufacturing the display device including the bending area BA.

The first touch electrode 740_R, the second touch electrode, and the second touch connection electrode 740_C may be disposed on the touch insulation layer 730.

The first touch electrode 740_R and the second touch electrode may be disposed to be spaced apart from each other at a predetermined interval. For example, the first touch electrodes 740_R, which are adjacent to each other in the first direction (or X-axis direction or a horizontal direction), may be disposed to be spaced apart from each other, and the first touch electrodes 740_R, which are adjacent to each other in the first direction (or X-axis direction), may be connected to the first touch connection electrode 720 through a hole of the touch insulation layer 730. In addition, the second touch electrodes, which are adjacent to each other in the second direction (or Y-axis direction or a vertical direction), may be disposed to be spaced apart from each other, and the second touch electrodes, which are adjacent to each other in the second direction (or Y-axis direction), may be connected by the second touch connection electrode 740_C formed on the same layer. For example, the second touch connection electrode 740_C may extend from the second touch electrode. However, the present specification is not limited thereto.

The first touch electrode 740_R, the second touch electrode, and the second touch connection electrode 740_C may be formed by the same process.

A protective layer 750 may be disposed on the first touch electrode 740_R, the second touch electrode, and the second touch connection electrode 740_C.

For example, the protective layer 750 may be a planarization layer, a touch planarization layer, a tenth insulation layer, or a third protective layer. However, the present specification is not limited thereto.

The touch drive circuit mounted in the circuit element 161 may receive a touch detection signal from the first touch electrode 740_R. In addition, the touch drive circuit may transmit a touch driving signal to the second touch electrode. The touch drive circuit may detect the user's touch by using mutual capacitance between the plurality of first touch electrodes 740_R and the second touch electrodes. For example, in case that a touch operation is performed on the display device 100, the capacitance may change between the first touch electrode 740_R and the second touch electrode. The touch drive circuit may detect a touch coordinate by detecting the change in capacitance.

In the display device 100 according to the embodiment of the present specification, a polarizing plate and a cover member may be disposed on the touch detection part 700. For example, although not illustrated, the polarizing plate may be disposed on the protective layer 750 in FIG. 5.

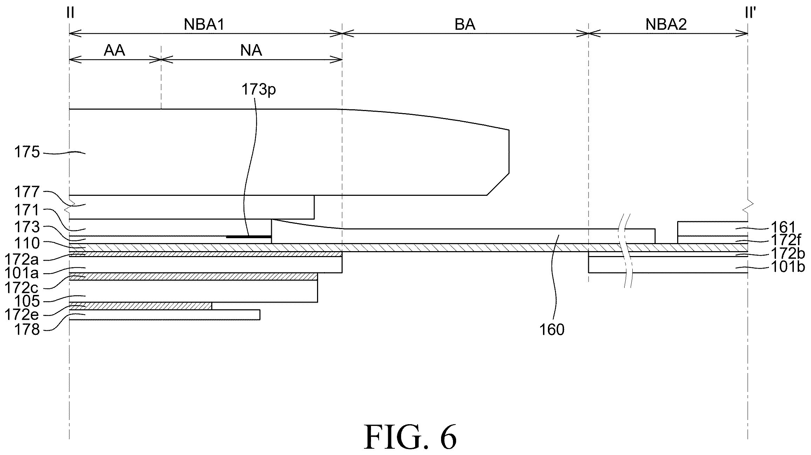

A cross-sectional structure of the display panel 110 described with reference to FIG. 2, particularly, a cross-sectional structure of the first non-display area between the display area AA and the bending area BA will be described with reference to FIGS. 6 to 8. Because some constituent elements illustrated in FIGS. 6 to 8 are substantially identical or similar to the constituent elements described with reference to FIG. 5, a detailed description thereof will be omitted.

FIG. 6 is a cross-sectional view taken along line II-II' in FIG. 2.

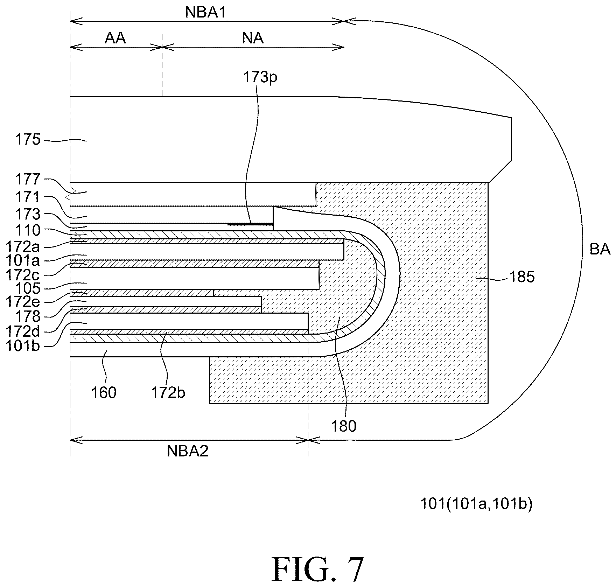

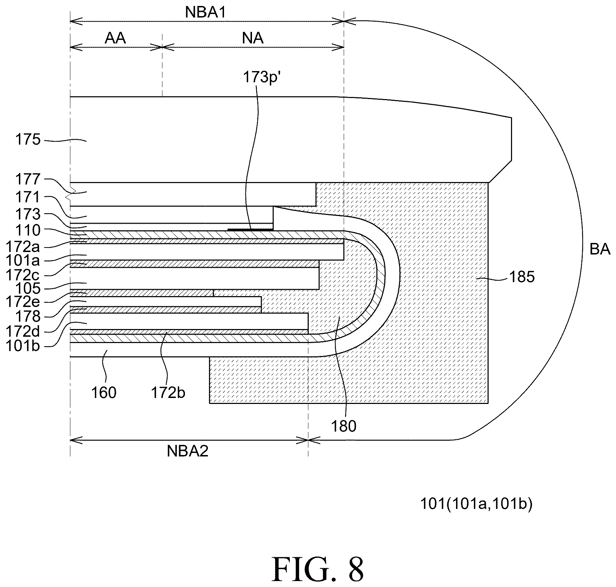

FIG. 7 is a view illustrating one example of a cross-section of the display device according to the embodiment of the present specification. Further, FIG. 8 is a view illustrating another example of the cross-section of the display device according to the embodiment of the present specification.

With reference to FIG. 6, in the display device 100 according to the embodiment of the present specification, a polarizing plate 171 and a cover member 175 may be disposed on a front surface (or top surface) of the display panel 110.

The polarizing plate 171 is disposed in the first non-bending area NBA1 of the display panel 110. The polarizing plate 171 may be disposed on the display panel 110 in the entire display area AA and at least a part of the first non-display area. The polarizing plate 171 may be disposed to at least correspond to the display area AA and suppress reflection of external light at an upper side of the display area AA. For example, external natural light may be introduced into the display device 100, and the introduced light may be reflected by a reflective layer included in an anode of the light-emitting element or reflected by an electrode disposed as opaque metal below the light-emitting element. The light beams, which are reflected as described above, may inhibit an image on the display device from being visually recognized well. The polarizing plate 171 may polarize, in a particular direction, the light introduced from the outside, thereby inhibiting the reflected light from being discharged again to the outside of the display device. For example, the polarizing plate 171 may include a polarizer and a protective film configured to protect the polarizer, or the polarizing plate 171 may be formed by applying a polarizing material to ensure flexibility.

A first bonding layer 173 is disposed between the polarizing plate 171 and the display panel 110 in the first non-bending area NBA1 of the display panel 110.

The first bonding layer 173 may include a material having bondability. The first bonding layer 173 may be made of a material such as pressure-sensitive adhesive (PSA) and fix the polarizing plate 171, which is provided above the first bonding layer 173, to the display panel 110. For example, the first bonding layer 173 may be disposed on the protective layer 750 of the display panel 110. The first bonding layer 173 will be described more specifically with reference to FIGS. 7 and 8.

A second bonding layer 177 may be interposed above the polarizing plate 171, and the cover member 175 may be disposed above the second bonding layer 177 and protect an external appearance of the display device 100.

The second bonding layer 177 may be made of a material having bondability. For example, the second bonding layer 177 may be made of optically clear adhesive (OCA) so as to bond the cover member 175, which is provided above the second bonding layer 177, to the polarizing plate 171.

The cover member 175 may be made of a material having impact resistance and light transmissivity to protect the display panel 110, other constituent elements, and the like from external impact, moisture, heat, and the like.

For example, the cover member 175 may be a substrate made of glass or a film made of a plastic material such as polymethylmethacrylate (PMMA), polyimide (PI), or polyethylene terephthalate (PET). However, the present specification is not limited thereto.

In addition, the cover member 175 may be referred to as various designations such as a cover window, a window cover, or a cover glass. However, the present specification is not limited thereto.

With reference to FIG. 6, in the display device 100 according to the embodiment of the present specification, a backplate 101 configured to support and protect the display panel 110 may be disposed on a rear surface of the display panel 110.

The backplate 101 may be made of a material having high thermal conductivity while having rigidity. For example, the backplate 101 may be made of a plastic material or a metallic material such as aluminum (Al), copper (Cu), zinc (Zn), silver (Ag), gold (Au), iron (Fe), stainless steel (SUS), or Invar. However, the present specification is not limited thereto.

A first backplate 101a is disposed on the rear surface of the display panel 110 in the first non-bending area NBA1, and a second backplate 101b is disposed on the rear surface of the display panel 110 in the second non-bending area NBA2.

The first backplate 101a enhances rigidity of the flexible display panel 110 while corresponding to the display area AA and supports the first non-bending area NBA1 of the display panel 110 so that the first non-bending area NBA1 may be maintained in a flat state.

The second backplate 101b enhances rigidity of the circuit element 161 and the display panel 110 having flexibility and supports the second non-bending area NBA2 of the display panel 110 so that the second non-bending area NBA2 may be maintained in a flat state.

The first backplate 101a and the second backplate 101b may be attached to the display panel 110 by using first and second bonding members 172a and 172b. The first and second bonding members 172a and 172b may each be made of a material having bondability, e.g., optically clear adhesive (OCA), pressure-sensitive adhesive (PSA), or the like. However, the present specification is not limited thereto.

With reference to FIGS. 7 and 8, the display panel 110 may include a curved portion positioned between the first non-bending area NBA1 and the second non-bending area NBA2, and the curved portion may correspond to the bending area BA maintained in a state of being bent at a predetermined curvature. For example, the curved portion bent in the bending area BA may have a "⊃" shape. For example, the curved portion may extend from a first non-bending area NBA1 and be bent rearward by 180°. Therefore, a second non-bending area NBA2 extending from the curved portion may be positioned on a rear surface of the first non-bending area NBA1 and overlap the first non-bending area NBA1. Therefore, as illustrated in FIG. 6, the circuit element 161, which is bonded to the display panel 110 by a sixth bonding member 172f on the second non-bending area NBA2, may also be positioned in a direction toward the rear surface of the display panel 110 in the first non-bending area NBA1. However, the present specification is not limited thereto. For example, the sixth bonding member 172f may be made of optically clear adhesive (OCA), pressure-sensitive adhesive (PSA), or the like. However, the present specification is not limited thereto.

Meanwhile, in order to ensure flexibility of the curved portion of the display panel 110 in the bending area BA and easily control a neutral surface using a first protective member 160, the backplate may not be positioned on the rear surface of the curved portion of the display panel 110.

With reference to FIG. 6, a support member 105 may be disposed on the rear surface of the first backplate 101a in the first non-bending area NBA1. In addition, with reference to FIGS. 7 and 8, the support member 105 is disposed between the first backplate 101a and the second backplate 101b in a state in which the bending area BA of the display panel 110 is bent.

The support member 105 may be bonded to the first backplate 101a and the second backplate 101b by third and fourth bonding member 172c and 172d respectively. For example, the support member 105 may be made of a plastic material such as polycarbonate (PC), polyimide (PI), polyethylene naphthalate (PEN), polyethylene terephthalate (PET), polymers, or a combination of these polymers.

Strength of the support member 105 made of these plastic materials may be controlled by adding additives for increasing a thickness and strength of the support member 105. Further, the support member 105 may be made of glass, ceramic, metal, other materials having rigidity, or combinations of the above-mentioned materials. For example, an additional barrier film 178 may be disposed between the support member 105 and the second backplate 101b, and the additional barrier film 178 may include a material having bondability and serve as a buffer or cushion. The additional barrier film 178 may be bonded to the support member 105 by a fifth bonding member 172e. However, the present specification is not limited thereto. The additional barrier film 178 may not be disposed.

The gate signal, the data signal, and the touch driving signal, which have been above described with reference to FIGS. 1 to 3, are transmitted from the external module to the pixel and the touch electrode in the display area AA through the connection line 140 disposed in the non-display area of the display device 100.

Some of the connection lines 140 disposed in the bending area BA receive a tensile force when the substrate 111 is bent. That is, portions of the connection lines 140 provided on the substrate 111 and extending in a direction identical to the bending direction may be subjected to the greatest tensile force, which may cause a crack or disconnection.

As illustrated in FIGS. 6 to 8, the first protective member 160 is disposed on the substrate 111 in the bending area BA to protect the connection line 140, which is disposed above the substrate 111 in the bending area BA, when the substrate 111 is bent. The first protective member 160 may be a micro-coating layer (MCL). However, the present specification is not limited thereto. The first protective member 160 may include resin and use ultraviolet (UV) curable acrylic-based resin or epoxy resin, for example. However, the present specification is not limited thereto.

In addition, the first protective member 160 may also be disposed in a partial area of the first non-bending area NBA1 adjacent to the bending area BA and/or a partial area of the second non-bending area NBA2.

The first protective member 160 may suppress a problem of a crack and permeation of external moisture occurring when the display panel 110 is bent. The first protective member 160 may suppress a problem of disconnection of the connection line 140 or permeation of external moisture and/or oxygen into the display panel 110 caused by external impact applied to the bending area BA after the substrate is bent.

In addition, in the display device 100 according to the embodiment of the present specification, an outer peripheral frame of the display device may be formed by using UV rays or thermosetting resin, instead of a metal frame in the related art, in order to reduce a bezel area.

With reference to FIGS. 7 and 8, a second protective member 185 and a third protective member 180 may be disposed in the entire curved portion of the display panel 110 and partial areas of the first and second non-bending areas NBA1 and NBA2, which are adjacent to the bending area BA, in the state in which the display panel 110 is bent.

The second protective member 185 may be an outer sealing material and disposed in a frame shape at four edges of the display device 100. However, the present specification is not limited thereto. The second protective member 185 may be disposed at a lower edge of the cover member 175 and cover the display panel 110 and the first protective member 160 that are bent. In addition, the second protective member 185 may be disposed to cover the second bonding layer 177 exposed to the lower edge of the cover member 175.

For example, the second protective member 185 may be configured as an epoxy mold. However, the present specification is not limited thereto. The second protective member 185 may be made of a UV-curable material. The second protective member 185 may be made of a UV-curable material to which a UV-curable oligomer, such as epoxy acrylate, urethane acrylate, polyester acrylate, urethane, or silicone acrylate, is added. However, the present specification is not limited thereto.

The third protective member 180 may be an inner sealing material. An internal space of the display panel 110, which is bent at a lower edge of the display device 100, may be filled with the third protective member 180.

For example, the third protective member 180 may be configured as an epoxy mold. However, the present specification is not limited thereto. The third protective member 180 may be made of a UV-curable material. The third protective member 180 may be made of a UV-curable material to which a UV-curable oligomer, such as epoxy acrylate, urethane acrylate, polyester acrylate, urethane, or silicone acrylate, is added. However, the present specification is not limited thereto.

Meanwhile, an outermost peripheral portion of the polarizing plate 171 and one end of the first protective member 160 may come into contact with each other in a first non-display area between the display area AA and the bending area BA of the display panel 110 according to the embodiment of the present specification during an operation at a general temperature (e.g., at room temperature). In addition, an outermost peripheral portion of the first bonding layer 173 and one end of the first protective member 160 may come into contact with each other in the first non-display area between the display area AA and the bending area BA of the display panel 110 during an operation at a general temperature (e.g., at room temperature).

However, in case that the display device 100 according to the embodiment of the present specification is exposed to an environment in which a temperature change exceeding a predetermined range occurs, thermal expansion and contraction of the polarizing plate 171 are repeated, such that separation may occur in at least one of a portion of an outer peripheral portion of the display panel 110 between the polarizing plate 171 and the display panel 110, a portion between a lateral portion of the polarizing plate 171 and one end of the first protective member 160, and a portion between the lateral portion of the polarizing plate 171 and a lateral portion of the second protective member 185. For this reason, the display panel 110 may crack in the outer peripheral portion of the first non-display area of the display panel 110.

For example, during the manufacturing process, the display device 100 may be exposed to a thermal cycle (TC) test environment in which an extremely low temperature and an extremely high temperature are periodically repeated in order to evaluate reliability of the display panel 110. In the TC test environment, the polarizing plate 171 repeatedly changes in states while thermally expanding at a high temperature higher than a predetermined range and contracting at a low temperature lower than the predetermined range, such that the polarizing plate 171 performs a motion in a horizontal direction. That is, in an extremely high-temperature situation in the TC test environment, the polarizing plate 171 thermally expands, and the outermost peripheral portion of the polarizing plate 171 is affected by a force applied in a direction toward the outer peripheral portion of the display panel 110. In an extremely low-temperature situation, the polarizing plate 171 contracts, and the outermost peripheral portion of the polarizing plate 171 is affected by a force applied in a direction toward the inside of the display panel 110.

Meanwhile, the polarizing plate 171 has a coefficient of thermal expansion (CTE) different from those of other constituent elements of the display device 100, particularly, the display panel 110, the first protective member 160, and the second protective member 185, such that the polarizing plate 171 may separate from the display panel 110, the first protective member 160, and the second protective member 185 during the process in which the polarizing plate 171 thermally expands and contracts repeatedly. For this reason, stress may be applied to the display panel 110, and the display panel 110 may crack.

For example, in an initial state in which no state change is caused by repeated thermal expansion and contraction of the polarizing plate 171 during the process of manufacturing the display device 100, a lateral portion of an outermost peripheral portion of the polarizing plate 171 and a lateral portion of an outermost peripheral portion of the first bonding layer 173 may be in a state of being in contact with and bonded to a lateral portion of one end of the first protective member 160 in the first non-display area adjacent to the bending area BA. In addition, in the above-mentioned initial state, the lateral portion of the outermost peripheral portion of the polarizing plate 171 and the lateral portion of the outermost peripheral portion of the first bonding layer 173 may be in a state of being in contact with and bonded to a lateral portion of the second protective member 185 in the remaining first non-display area excluding the area adjacent to the bending area BA.

After this initial state, when the polarizing plate 171 contracts inward in case that the display device 100 is exposed to the TC test environment and the polarizing plate 171 thermally expands and contracts repeatedly, a force, which is generated by the contraction of the polarizing plate 171, is periodically applied to the display panel 110 because the polarizing plate 171 and the display panel 110 are bonded by the first bonding layer 173. In this case, because the display panel 110 has a coefficient of thermal expansion different from that of the polarizing plate 171, the display panel 110 may react against a contractive force of the polarizing plate 171, which may cause separation and crack of the outer peripheral portion of the display panel 110. In addition, when the polarizing plate 171 contracts in the direction toward the inside of the display panel 110, the first protective member 160 and the second protective member 185 also contract in a direction toward the outside of the display panel 110, such that the separation may occur between each of the lateral portion of the outermost peripheral portion of the polarizing plate 171 and the lateral portion of the first bonding layer 173 and the lateral portion of the first protective member 160, and the separation may occur between each of the lateral portion of the outermost peripheral portion of the polarizing plate 171 and the lateral portion of the first bonding layer 173 and the lateral portion of the second protective member 185. In case that the separation occurs between each of the first protective member 160 and the second protective member 185 and the polarizing plate 171 as described above, stress may be applied to the outer peripheral portion of the display panel 110, which may cause a crack defect.

In the display device 100 of the embodiment of the specification, a non-bonding pattern 173p is disposed on the outer peripheral portion of the first bonding layer 173, such that a part of an outer periphery of the first bonding layer 173 may perform a motion independently of the polarizing plate 171. At least one non-bonding pattern 173p may overlap at least a part of an outermost peripheral portion of the polarizing plate 171 and provided on one surface of the first bonding layer 173. Therefore, the influence of the force generated by the motion of the polarizing plate 171 on other constituent elements may be reduced even in a temperature environment in which the polarizing plate 171 may thermally expand and contract repeatedly. Therefore, it is possible to suppress the separation between the polarizing plate 171 and other constituent elements and suppress the occurrence of a crack by mitigating stress to be applied to the display panel 110.

The first bonding layer 173 of the embodiment of the specification may include a non-bonding pattern area provided on a top or bottom surface of the outer peripheral portion, and a bonding area that is the remaining area excluding the non-bonding pattern area. The non-bonding pattern area of the first bonding layer 173 may overlap the outermost peripheral portion of the polarizing plate 171.

With reference to FIGS. 2 and 6 to 8 together, the outer peripheral portion of the first bonding layer 173 includes the non-bonding pattern area in the first non-display area between the display area AA and the bending area BA of the display panel 110.

For example, with reference to FIG. 7, the non-bonding pattern 173p may be disposed on a top surface of the first bonding layer 173 that adjoins the polarizing plate 171 in the non-bonding pattern area provided on the outermost peripheral portion of the first bonding layer 173.

In another example, with reference to FIG. 8, a non-bonding pattern 173p' is disposed on a bottom surface of the first bonding layer 173 that adjoins the display panel 110 in the non-bonding pattern area provided on the outermost peripheral portion of the first bonding layer 173.

The non-bonding pattern 173p, which is disposed on the top surface of the first bonding layer 173 according to the embodiment of the present specification, or the non-bonding pattern 173p', which is disposed on the bottom surface of the first bonding layer 173, may integrally extend along a boundary with the bending area BA. For example, as illustrated in FIG. 2, the non-bonding pattern 173p may have a bar shape. However, the specification is not limited thereto. The non-bonding pattern 173p' may also have a bar shape. However, the specification is not limited thereto.

For example, the non-bonding pattern 173p or the non-bonding pattern 173p' may be a non-bonding pattern member made of a material different from that of the first bonding layer 173. The non-bonding pattern member may have a bonding force only on one of two opposite surfaces thereof, and one surface of the non-bonding pattern member and the top or bottom surface of the first bonding layer 173 may be bonded in the non-bonding pattern area. The non-bonding pattern 173p or the non-bonding pattern 173p' may be disposed by being applied or attached onto the top or bottom surface of the first bonding layer 173 in the non-bonding pattern area. For example, the non-bonding pattern 173p or the non-bonding pattern 173p' may be a single tape member having a bonding force applied only to one of two opposite surfaces. However, the specification is not limited thereto. In case that the non-bonding pattern 173p or the non-bonding pattern 173p' is a single tape member, one surface having a bonding force is attached to the top or bottom surface of the first bonding layer 173, and the other surface having no bonding force adjoins the polarizing plate 171 or the display panel 110 without being bonded to the polarizing plate 171 or the display panel 110. For example, the non-bonding pattern 173p or the non-bonding pattern 173p' may be made of resin. However, the present specification is not limited thereto. In case that the non-bonding pattern 173p or the non-bonding pattern 173p' is a non-bonding pattern member made of resin, the non-bonding pattern 173p or the non-bonding pattern 173p' may be applied onto the top or bottom surface of the first bonding layer 173 in the non-bonding pattern area.

In another example, the non-bonding pattern 173p or the non-bonding pattern 173p' may be a portion of the non-bonding pattern area from which a bonding force of the top or bottom surface of the first bonding layer 173 is removed by laser trimming.

In still another example, the non-bonding pattern 173p or the non-bonding pattern 173p' may be a portion of the non-bonding pattern area from which a bonding force of the top or bottom surface of the first bonding layer 173 is removed by using a chemical product. For example, a grease remover, isopropyl alcohol (IPA), an acetone-based chemical product, or the like may be used as the chemical product. However, the specification is not limited thereto.

With the above-mentioned method of disposing the non-bonding pattern, the bottom or top surface having the bonding force in the non-bonding pattern area of the first bonding layer 173 may be bonded to the display panel 110 or the polarizing plate 171, and the top or bottom surface, from which the bonding force is removed, may not be bonded to the polarizing plate 171 or the display panel 110.

Therefore, when the polarizing plate 171 performs a motion in one direction while thermally expanding or contracting, the bonding area of the first bonding layer 173 performs a motion together with the polarizing plate 171, but the non-bonding pattern area of the first bonding layer 173 performs a motion independently of the polarizing plate 171. When the state of the display panel 110 switches from a first state in which the lateral portion of the outermost peripheral portion of the polarizing plate 171 (or the lateral portion of the polarizing plate 171) and the lateral portion of the outermost peripheral portion of the first bonding layer 173 (or the lateral portion of the first bonding layer 173) are in contact with the lateral portion of the first protective member 160 in the first non-display area between the display area AA and the bending area BA of the display panel 110 to a second state in which the lateral portion of the outermost peripheral portion of the polarizing plate 171 (or the lateral portion of the polarizing plate 171) is not in contact with the lateral portion of the first protective member 160, the lateral portion of the outermost peripheral portion of the polarizing plate 171 and the lateral portion of the first protective member 160 are spaced apart from each other at a predetermined distance, but at least a part of the lateral portion of the outermost peripheral portion of the first bonding layer 173 (or the lateral portion of the first bonding layer 173) may be kept in a state of being in contact with the first protective member 160 or spaced apart from the lateral portion of the first protective member 160 at a distance shorter than a distance at which the lateral portion of the outermost peripheral portion of the polarizing plate 171 (or the lateral portion of the polarizing plate 171) and the lateral portion of the first protective member 160 are spaced apart from each other.

For example, in case that the non-bonding pattern 173p is disposed on the top surface of the first bonding layer 173, a force generated by the motion of the polarizing plate 171 does not affect the non-bonding pattern 173p disposed above the first bonding layer 173, such that the force generated by the motion of the polarizing plate 171 may not affect even a portion of the outer peripheral portion of the display panel 110, which overlaps the non-bonding pattern area, or the influence of the force may be reduced. In addition, in case that the non-bonding pattern 173p' is disposed on the bottom surface of the first bonding layer 173, the influence of the force generated by the motion of the polarizing plate 171 on the non-bonding pattern 173p' disposed below the first bonding layer 173 may be reduced, and the force generated by the motion of the polarizing plate 171 may not affect the portion of the outer peripheral portion of the display panel 110 that overlaps the non-bonding pattern area.

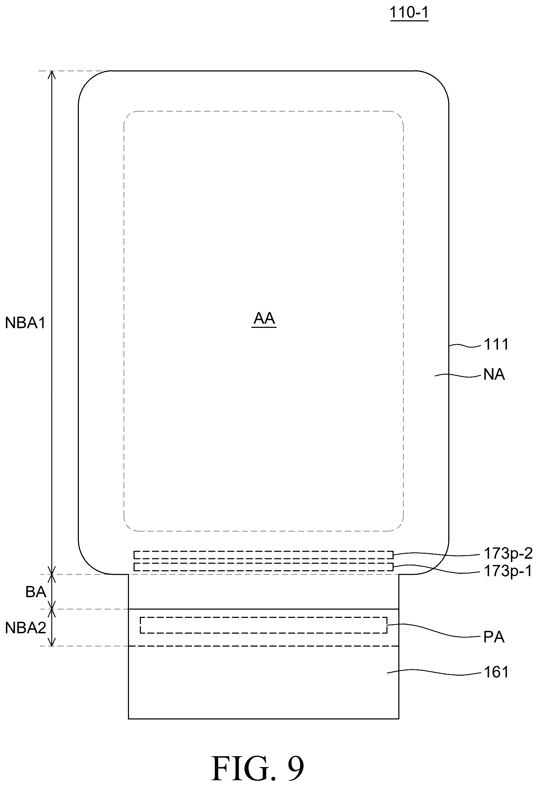

FIG. 9 is a top plan view of a display device of another embodiment of the specification.

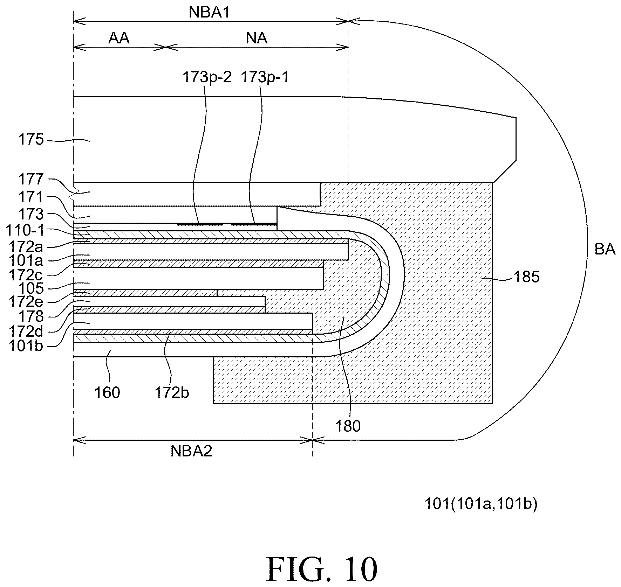

FIG. 10 is a view illustrating a cross-section of the display device of another embodiment of the specification.

The display device of another embodiment of the specification in FIGS. 9 and 10 may have a structure identical or similar to the structure of the display device of the embodiment of the specification described above with reference to FIGS. 2 to 8, except for a shape of the non-bonding pattern of the first bonding layer 173 on a display panel 110-1. Therefore, for convenience of description, a repeated description of the identical or similar constituent elements will be omitted.

With reference to FIG. 9, in the first non-display area between the display area AA and the bending area BA of the display panel 110-1 in the display device of another embodiment of the specification, the first bonding layer 173 includes a first non-bonding pattern area of the outer peripheral portion overlapping the outermost peripheral portion of the polarizing plate 171, and a second non-bonding pattern area disposed to be closer to the display area AA than the first non-bonding pattern area to the display area AA.

With reference to FIG. 10, a first non-bonding pattern 173p-1 may be disposed on the top surface of the first bonding layer 173 that adjoins the polarizing plate 171 in the first non-bonding pattern area provided on the outermost peripheral portion of the first bonding layer 173. However, the present specification is not limited thereto. For example, the first non-bonding pattern 173p-1 may be disposed on the bottom surface of the first bonding layer 173 that adjoins the display panel 110-1 in the first non-bonding pattern area of the first bonding layer 173.

In addition, a second non-bonding pattern 173p-2 may be disposed on the top surface of the first bonding layer 173 that adjoins the polarizing plate 171 in the second non-bonding pattern area disposed inward of the outermost peripheral portion of the first bonding layer 173. However, the present specification is not limited thereto. For example, the second non-bonding pattern 173p-2 may be disposed on the bottom surface of the first bonding layer 173 that adjoins the display panel 110-1 in the second non-bonding pattern area of the first bonding layer 173. The second non-bonding pattern 173p-2 may be configured to surround the display area AA, and disposed to be closer to the display area AA than the first non-bonding pattern 173p-1 to the display area AA, as shown in FIG. 9.

As described above, the multiple non-bonding patterns are disposed on the outer peripheral portion of the first bonding layer 173, such that the influence of the force generated by the motion made by the thermal expansion and contraction of the polarizing plate 171 on other constituent elements may be further reduced.

The first non-bonding pattern 173p-1 and the second non-bonding pattern 173p-2 disposed on a top surface or a bottom surface of the first bonding layer 173 according to another embodiment of the present specification may integrally extend along the boundary with the bending area BA. For example, as illustrated in FIG. 9, the first non-bonding pattern 173p-1 and the second non-bonding pattern 173p-2 may each have a bar shape. However, the specification is not limited thereto.

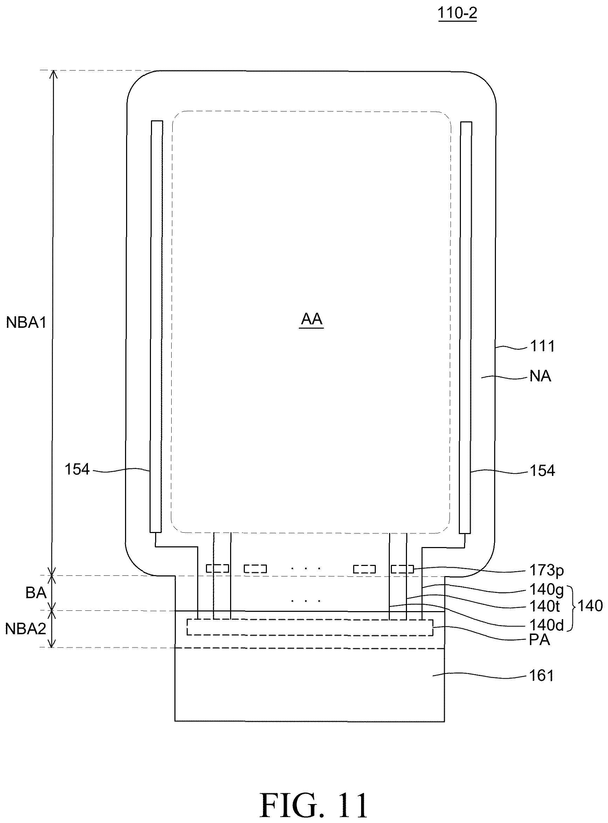

FIG. 11 is a top plan view of a display device of still another embodiment of the specification.

The display device of still another embodiment of the specification in FIG. 11 may have a structure identical or similar to the structure of the display device according to the embodiment of the specification described above with reference to FIGS. 2 to 8, except for a shape of the non-bonding pattern of the first bonding layer 173 on a display panel 110-2. Therefore, for convenience of description, a repeated description of the identical or similar constituent elements will be omitted.

With reference to FIG. 11, in the first non-display area between the display area AA and the bending area BA of the display panel 110-2 in the display device according to still another embodiment of the specification, the first bonding layer 173 includes a plurality of non-bonding pattern areas spaced apart from one another along the boundary with the bending area BA. In the first non-display area between the display area AA and the bending area BA of the display panel 110-2, cross-sections of the plurality of non-bonding pattern areas may be identical or similar to those illustrated in FIG. 7 or 8.

In each of the plurality of non-bonding pattern areas, the non-bonding pattern 173p may be disposed on the top or bottom surface of the first bonding layer 173.

For example, the plurality of non-bonding pattern areas, which are spaced apart from one another along the boundary with the bending area BA, may each overlap the outermost peripheral portion of the polarizing plate 171. In addition, the plurality of non-bonding patterns 173p, which are spaced apart from one another along the boundary with the bending area BA, may each overlap the touch connection line 140t in the first non-display area between the display area AA and the bending area BA and extending to the display area AA.

As described above, the plurality of non-bonding patterns 173p, which are spaced apart from one another along the boundary with the bending area BA, are disposed, such that it is possible to maintain the bonding force between the polarizing plate 171 and the display panel 110-2 and efficiently suppress the separation of the peripheral area of the touch connection line 140t in which the probability of the occurrence of a crack of the display panel 110-2 caused by the separation is relatively high in comparison with the other areas.

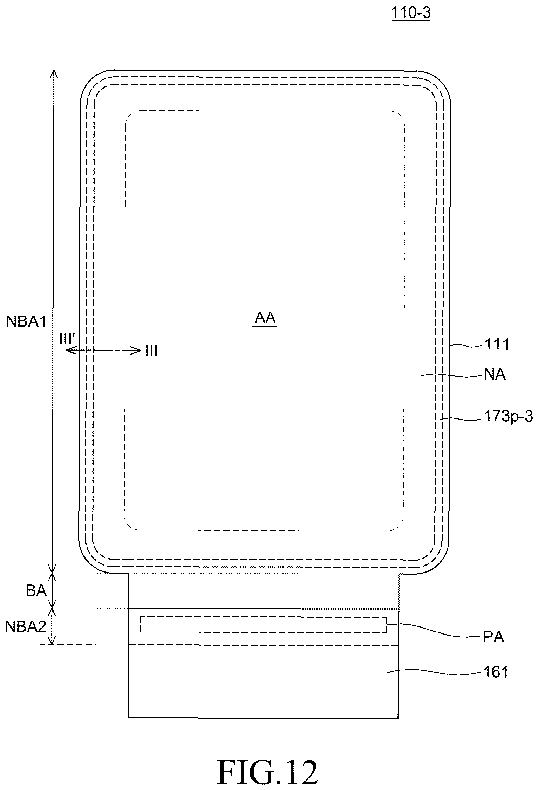

FIG. 12 is a top plan view of a display device of yet another embodiment of the specification.

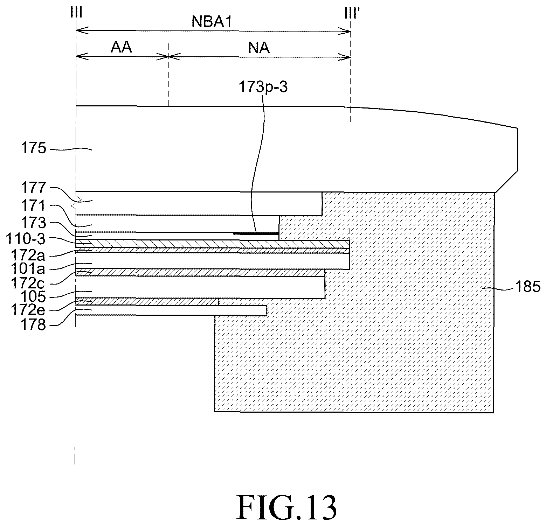

FIG. 13 is a cross-sectional view taken along line III-III' in FIG. 12.

The display device of yet another embodiment of the specification in FIGS. 12 and 13 may have a structure identical or similar to the structure of the display device according to the embodiment of the specification described above with reference to FIGS. 2 to 8, except for a shape of the non-bonding pattern of the first bonding layer 173 on a display panel 110-3. Therefore, for convenience of description, a repeated description of the identical or similar constituent elements will be omitted.

With reference to FIG. 12, the display device of yet another embodiment of the specification includes a non-bonding pattern area provided on the outer peripheral portion of the first bonding layer 173 and configured to overlap the outermost peripheral portion of the polarizing plate 171 not only between the display area AA and the bending area BA of the first non-display area of the display panel 110-3 but also over the entire area. For example, the non-bonding pattern area of the first bonding layer 173 may be disposed in a closed loop shape integrally extending along the outermost peripheral portion of the polarizing plate 171 and configured to surround the display area AA.

FIG. 13 illustrates a cross-section of a non-bonding pattern area provided in an area other than an area adjacent to the bending area BA in the first non-display area that surrounds the display area AA of the display panel 110-3. The cross-section of the non-bonding pattern area provided in the area adjacent to the bending area BA in the first non-display area, which surrounds the display area AA of the display panel 110-3, may be identical or similar to that illustrated in FIG. 7 or 8.

With reference to FIG. 13, a non-bonding pattern 173p-3 may be disposed on the top surface of the first bonding layer 173 that adjoins the polarizing plate 171 in the non-bonding pattern area provided on the outermost peripheral portion of the first bonding layer 173. However, the present specification is not limited thereto. For example, the non-bonding pattern 173p-3 may be disposed on the bottom surface of the first bonding layer 173 that adjoins the display panel 110-3 in the non-bonding pattern area of the first bonding layer 173.

As described above, the non-bonding pattern 173p-3 is disposed to surround the display area AA in the entire first non-display area that surrounds the display area AA of the display panel 110-3, such that the separation between the polarizing plate 171 and the display panel 110-3 and the occurrence of a crack may be suppressed not only in the area adjacent to the bending area BA but also in the entire area of the display panel 110-3.

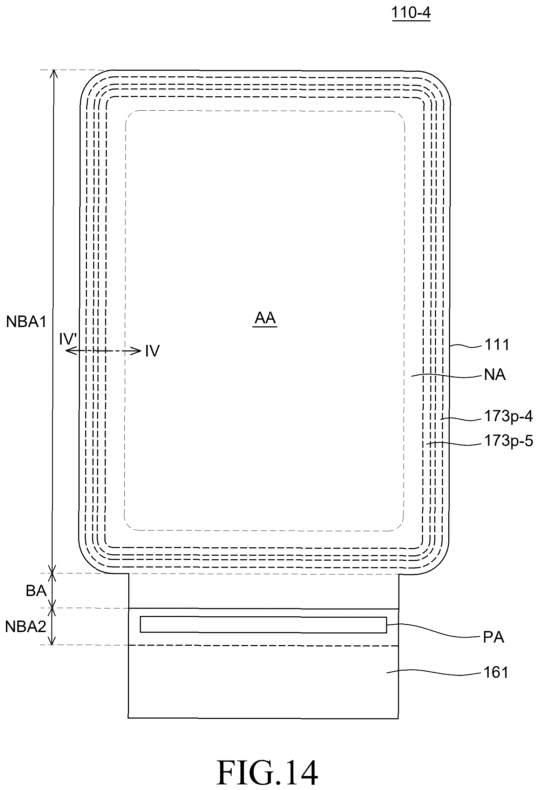

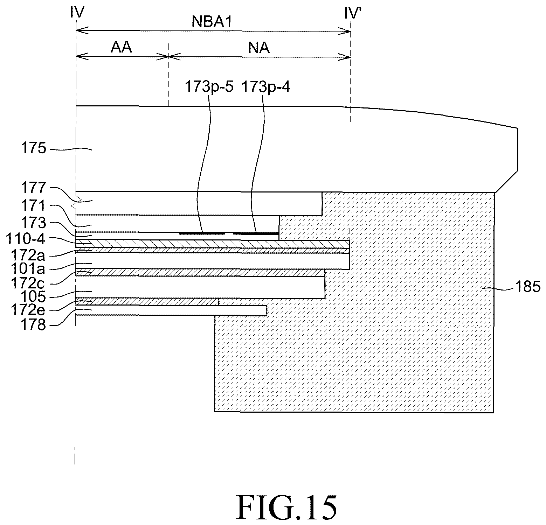

FIG. 14 is a top plan view of a display device of still yet another embodiment of the specification. FIG. 15 is a cross-sectional view taken along line IV-IV' in FIG. 14.

The display device of still yet another embodiment of the specification in FIGS. 14 and 15 may have a structure identical or similar to the structure of the display device of the embodiment of the specification described above with reference to FIGS. 2 to 8, except for a shape of the non-bonding pattern of the first bonding layer 173 on a display panel 110-4. Therefore, for convenience of description, a repeated description of the identical or similar constituent elements will be omitted.

With reference to FIG. 14, in the display device of still yet another embodiment of the specification, the first bonding layer 173 includes a first non-bonding pattern area of the outer peripheral portion overlapping the outermost peripheral portion of the polarizing plate 171, and a second non-bonding pattern area disposed to be closer to the display area AA than the first non-bonding pattern area to the display area AA not only between the display area AA and the bending area BA of the first non-display area of a display panel 110-4 but also over the entire area of the display panel 110-4. The second non-bonding pattern area may be spaced apart from the first non-bonding pattern area and disposed inward of the first non-bonding pattern area. For example, the first and second non-bonding pattern areas of the first bonding layer 173 may each be disposed in a closed loop shape integrally extending along the outer peripheral portion of the polarizing plate 171 and configured to surround the display area AA.

FIG. 15 illustrates cross-sections of the first and second non-bonding pattern areas provided in an area other than an area adjacent to the bending area BA in the first non-display area that surrounds the display area AA of the display panel 110-4. The cross-section of the non-bonding pattern area provided in the area adjacent to the bending area BA in the first non-display area, which surrounds the display area AA of the display panel 110-4, may be identical or similar to that illustrated in FIG. 10.

With reference to FIG. 15, a first non-bonding pattern 173p-4 may be disposed on the top surface of the first bonding layer 173 that adjoins the polarizing plate 171 in the first non-bonding pattern area provided on the outermost peripheral portion of the first bonding layer 173. However, the present specification is not limited thereto. For example, the first non-bonding pattern 173p-4 may be disposed on the bottom surface of the first bonding layer 173 that adjoins the display panel 110-4 in the first non-bonding pattern area of the first bonding layer 173.

In addition, a second non-bonding pattern 173p-5 may be disposed on the top surface of the first bonding layer 173 that adjoins the polarizing plate 171 in the second non-bonding pattern area disposed inward of the outermost peripheral portion of the first bonding layer 173. However, the present specification is not limited thereto. For example, the second non-bonding pattern 173p-5 may be disposed on the bottom surface of the first bonding layer 173 that adjoins the display panel 110-4 in the second non-bonding pattern area of the first bonding layer 173.

As described above, the multiple non-bonding patterns are disposed on the outer peripheral portion of the first bonding layer 173 in the entire first non-display area that surrounds the display area AA of the display panel 110-4, such that the influence of the force generated by the motion made by the thermal expansion and contraction of the polarizing plate 171 on the other constituent elements may be reduced. Further, the separation between the polarizing plate 171 and the display panel 110-4 and the occurrence of a crack may be suppressed not only in the area adjacent to the bending area BA but also in the entire area of the display panel 110-4.

Although the embodiments have been described in detail with reference to the accompanying drawings, the disclosure is not limited thereto and may be embodied in many different forms without departing from the technical concept. Therefore, the embodiments are provided for illustrative purposes only but not intended to limit the technical concept of the disclosure. The scope of the technical concept of the disclosure is not limited thereto. Therefore, it should be understood that the above-described embodiments are illustrative in all aspects and do not limit the disclosure.

## Claims

1. A display device comprising:
a display panel (110) including a non-bending area (NBA) and a bending area (BA) extending from one side of the non-bending area (NBA), the non-bending area (NBA) including a display area (AA) having a plurality of light-emitting elements (500), and a non-display area (NA) adjacent to the display area (AA);
a polarizing plate (171) disposed on the display panel (110) in the non-bending area (NBA);
a bonding layer (173) disposed between the display panel (110) and the polarizing plate (171) in the non-bending area (NBA); and
at least one non-bonding pattern (173p) overlapping at least a part of an outermost peripheral portion of the polarizing plate (171) and provided on one surface of the bonding layer (173).

2. The display device of claim 1, wherein
the at least one non-bonding pattern (173p-1, 173p-2) is provided in the non-display area (NA) between the display area (AA) and the bending area (BA); and/or
the at least one non-bonding pattern (173p-1, 173p-2) includes a first non-bonding pattern (173p-1) extending along a boundary with the bending area (BA); and /or
the at least one non-bonding pattern 173p-1, 173p-2) further includes a second non-bonding pattern (173p-2) disposed along the boundary with the bending area (BA) and disposed to be closer to the display area (AA) than the first non-bonding pattern (173p-1) to the display area (DA).

3. The display device of claim 1 or 2, wherein the at least one non-bonding pattern (173p-1, 173p-2) includes a plurality of first non-bonding patterns (173p) spaced apart from one another along a boundary with the bending area (BA).

4. The display device of claim 1, 2 or 3, further comprising:
an encapsulation part (600) configured to cover the plurality of light-emitting elements (500) in the display area (AA);
a touch buffer layer (730) disposed on the encapsulation part (600);
a plurality of touch electrodes (740) disposed on the touch buffer layer (730); and
a plurality of touch connection lines (720) disposed in the non-display area (NDA) between the display area (AA) and the bending area (BA), extending to the display area (AA), and electrically connected to the plurality of touch electrodes touch electrodes (230),
preferably the plurality of first non-bonding patterns (173-1) each overlap the touch connection line (720).

5. The display device of any one of the preceding claims, wherein
the at least one non-bonding pattern (173p) includes a first non-bonding pattern (713p-1) disposed in the non-display area (NA) and configured to surround the display area (AA); and/or
the at least one non-bonding pattern (173p-1, 173p-2) includes a second non-bonding pattern (173p-2) disposed in the non-display area (NA), configured to surround the display area (AA), and disposed to be closer to the display area (AA) than the first non-bonding pattern to the display area (AA)

6. The display device of any one of the preceding claims, further comprising:
a protective member (160) disposed on the display panel (110) in the bending area (BA),
wherein a lateral portion of the polarizing plate (171) and a lateral portion of the bonding layer (173) are each in contact with a lateral portion of the protective member (160) in a first state,
wherein the lateral portion of the polarizing plate (171) is not in contact with the lateral portion of the protective member (160) in a second state,
preferably a distance between the lateral portion of the bonding layer (173) and the lateral portion of the protective member (160) is shorter than a distance between the lateral portion of the polarizing plate (171) and the lateral portion of the protective member (160) when the state of the display panel (110) switches from the first state to the second state.

7. The display device of any one of the preceding claims, wherein one surface of the at least one non-bonding pattern (173p-1, 173p-2) adjoins the bonding layer (173) and has a bonding force, and the other surface of the at least one non-bonding pattern (173p-1, 173p-2) adjoins the polarizing plate (171) or the display panel (110) and has no bonding force.

8. The display device of any one of the preceding claims, wherein the non-display area (NA) including a first non-display area configured to surround the display area (AA), wherein the bending area (BA) extends from one side of the first non-display area, and a second non-display area extending from the bending area (BA).

9. The display device of claim 8, wherein the polarizing plate (171) is disposed on the display panel (110) in the entire display area (AA) and at least a part of the first non-display area.

10. The display device any one of the preceding claims, wherein the bonding layer (173) includes at least one non-bonding pattern area provided on a top and/or bottom surface of an outer peripheral portion thereof, and a bonding area excluding the non-bonding pattern area.

11. The display device of claim 10, wherein the at least one non-bonding pattern area includes a first non-bonding pattern area configured to overlap an outermost peripheral portion of the polarizing plate (171) and integrally extending along the outermost peripheral portion of the polarizing plate (171).

12. The display device of claim 10 or 11, wherein the first non-bonding pattern area is provided in a first non-display area between the display area (AA) and the bending area (BA); and/or
the first non-bonding pattern area surrounds the display area (AA) in the first non-display area; and/or
the at least one non-bonding pattern area further includes a second non-bonding pattern area spaced apart from the first non-bonding pattern area, disposed inward of the first non-bonding pattern area, and integrally extending along the outermost peripheral portion of the polarizing plate (171).

13. The display device of claim 12, wherein the first non-bonding pattern area and the second non-bonding pattern area are provided in a first non-display area between the display area (AA) and the bending area (BA) and/or the first non-bonding pattern area and the second non-bonding pattern area surround the display area (AA) in the first non-display area.

14. The display device of any one of the preceding claims, wherein a bottom surface of the bonding layer (173) having a bonding force is bonded to the display panel (110) and a top surface of the bonding layer (173), from which the bonding force is removed, is not bonded to the polarizing plate in the at least one non-bonding pattern area, or
wherein a top surface of the bonding layer (173) having a bonding force is bonded to the polarizing plate (171) and a bottom surface of the bonding layer (173), from which the bonding force is removed, is not bonded to the display panel (110) in the at least one non-bonding pattern area.

15. The display device of any one of the preceding claims, further comprising:
a non-bonding pattern member having a bonding force only on one of two opposite surfaces thereof,
wherein one surface of the non-bonding pattern member and the top or bottom surface of the bonding layer (173) are bonded in the non-bonding pattern area.
